# EUROPEAN PATENT APPLICATION

(11) **EP 1 881 539 A2**
(43) Date of publication of application: **23.01.2008**
(21) Application number: 07013613.0
(22) Date of filing: 11.07.2007
(51) Int. Cl.: H01L 45/00

(54) **Phase change memory cell having a step-like programming characteristic**

(30) Priority: 18.07.2006 US 488313
(71) Applicant: Qimonda North America Corp., Cary, NC 27513 (US)
(72) Inventor: Happ, Thomas Dr., 10591 Tarrytown NY (US); Philipp, Jan Boris, 10566 Peekskill NY (US)
(74) Representative: Jehle, Volker Armin

(57) **Abstract**

A memory cell (200a) includes a first electrode (202), a second electrode (204), and phase change material (208) contacting the first electrode and the second electrode. The phase change material has a step-like programming characteristic realised by multiple rectangular phase change portions (210a-210e). The first electrode, the second electrode, and the phase change material form a planar or bridge phase change memory cell.

## Description

### Cross-Reference to Related Applications

This Utility Patent Application is related to U.S. Patent Application Serial Number ##/###,###, Attorney Docket Number I331.303.101, entitled «PHASE CHANGE MEMORY CELL HAVING A STEP-LIKE PROGRAMMING CHARACTERISTIC,» and U.S. Patent Application Serial Number ##/###,###, Attorney Docket Number 1331.304.101, entitled "PHASE CHANGE MEMORY CELL HAVING A STEP-LIKE PROGRAMMING CHARACTERISTIC," both filed on the same day as the present application, and both of which are incorporated herein by reference.

### Background

One type of memory is resistive memory. Resistive memory utilizes the resistance value of a memory element to store one or more bits of data. For example, a memory element programmed to have a high resistance value may represent a logic "1" data bit value, and a memory element programmed to have a low resistance value may represent a logic "0" data bit value. The resistance value of the memory element may be switched electrically by applying a voltage pulse or a current pulse to the memory element. One type of resistive memory is phase change memory. Phase change memory uses a phase change material for the resistive memory element.

Phase change memories are based on phase change materials that exhibit at least two different states. Phase change material may be used in memory cells to store bits of data. The states of phase change material may be referred to as amorphous and crystalline states. The states may be distinguished because the amorphous state generally exhibits higher resistivity than does the crystalline state. Generally, the amorphous state involves a more disordered atomic structure, while the crystalline state involves a more ordered lattice. Some phase change materials exhibit more than one crystalline state, e.g. a face-centered cubic (FCC) state and a hexagonal closest packing (HCP) state. These two crystalline states have different resistivities and may be used to store bits of data. In the following description, the amorphous state generally refers to the state having the higher resistivity, and the crystalline state generally refers to the state having the lower resistivity.

Phase change in the phase change materials may be induced reversibly. In this way, the memory may change from the amorphous state to the crystalline state and from the crystalline state to the amorphous state in response to temperature changes. The temperature changes to the phase change material may be achieved by driving current through the phase change material itself, or by driving current through a resistive heater adjacent the phase change material. With both of these methods, controllable heating of the phase change material causes controllable phase change within the phase change material.

A phase change memory including a memory array having a plurality of memory cells that are made of phase change material may be programmed to store data utilizing the memory states of the phase change material. One way to read and write data in such a phase change memory device is to control a current and/or a voltage pulse that is applied to the phase change material. The level of current and/or voltage generally corresponds to the temperature induced within the phase change material in each memory cell.

To achieve higher density phase change memories, a phase change memory cell can store multiple bits of data. Multi-bit storage in a phase change memory cell can be achieved by programming the phase change material to have intermediate resistance values or states. If the phase change memory cell is programmed to one of three different resistance levels, 1.5 bits of data per cell can be stored. If the phase change memory cell is programmed to one of four different resistance levels, two bits of data per cell can be stored, and so on. For simplicity, the description in this disclosure is substantially focused on four different resistance levels or states and two bits of data per cell. This is for illustrative purposes only, however, and not intended to limit the scope of the invention. In principle it is possible to store three or more states.

To program a phase change memory cell to an intermediate resistance value, the amount of crystalline material coexisting with amorphous material and hence the cell resistance is controlled via a suitable write strategy. Reliable and repeatable programming of a phase change memory cell requires that substantially similar programming conditions result in substantially similar resistance values. Substantially similar programming conditions including substantially identical current and/or voltage pulses applied to typical phase change memory cells, however, may result in different resistance values due to fabrication fluctuations, electrical noise, temperature variations, or other temporal fluctuations.

For these and other reasons, there is a need for the present invention.

### Summary

One embodiment of the present invention provides a memory cell. The memory cell includes a first electrode, a second electrode, and phase change material contacting the first electrode and the second electrode. The phase change material has a step-like programming characteristic. The first electrode, the second electrode, and the phase change material form a planar or bridge phase change memory cell.

### Brief Description of the Drawings

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description.

The elements of the drawings are not necessarily to scale relative to each other. Like reference numerals designate corresponding similar parts.
Figure 1A is a block diagram illustrating one embodiment of a memory device.
Figure 1B is a graph illustrating one embodiment of a step-like programming characteristic for phase change memory cells.
Figure 2A illustrates a top view of one embodiment of a phase change memory cell.
Figure 2B illustrates a side cross-sectional view of one embodiment of a phase change memory cell.
Figure 2C illustrates a top view of another embodiment of a phase change memory cell.
Figure 2D illustrates a top view of another embodiment of a phase change memory cell.
Figure 2E illustrates a top view of another embodiment of a phase change memory cell.
Figure 3A illustrates a top view of another embodiment of a phase change memory cell.
Figure 3B illustrates a top view of another embodiment of a phase change memory cell.
Figure 3C illustrates a top view of another embodiment of a phase change memory cell.
Figure 3D illustrates a top view of another embodiment of a phase change memory cell.
Figure 4A illustrates a top view of another embodiment of a phase change memory cell.
Figure 4B illustrates a side cross-sectional view of another embodiment of a phase change memory cell.
Figure 4C illustrates a top view of another embodiment of a phase change memory cell.
Figure 4D illustrates a top view of another embodiment of a phase change memory cell.
Figure 4E illustrates a top view of another embodiment of a phase change memory cell.
Figure 5A illustrates a top view of another embodiment of a phase change memory cell.
Figure 5B illustrates a side cross-sectional view of another embodiment of a phase change memory cell.
Figure 5C illustrates a top view of another embodiment of a phase change memory cell.
Figure 5D illustrates a top view of another embodiment of a phase change memory cell.
Figure 5E illustrates a top view of another embodiment of a phase change memory cell.
Figure 6A illustrates a top view of another embodiment of a phase change memory cell.
Figure 6B illustrates a top view of another embodiment of a phase change memory cell.
Figure 6C illustrates a top view of another embodiment of a phase change memory cell.
Figure 6D illustrates a top view of another embodiment of a phase change memory cell.
Figure 7A illustrates a top view of another embodiment of a phase change memory cell.
Figure 7B illustrates a top view of another embodiment of a phase change memory cell.
Figure 7C illustrates a top view of another embodiment of a phase change memory cell.
Figure 7D illustrates a top view of another embodiment of a phase change memory cell.
Figure 8A illustrates a top view of one embodiment of a preprocessed wafer.
Figure 8B illustrates a side cross-sectional view of one embodiment of the preprocessed wafer.
Figure 9 illustrates a side cross-sectional view of one embodiment of the preprocessed wafer and a phase change material layer.
Figure 10 illustrates a top view of one embodiment of the preprocessed wafer and a step-like phase change material layer after etching the phase change material layer.
Figure 11 illustrates a side cross-sectional view of one embodiment of the preprocessed wafer, the phase change material layer, and an additional insulation material layer.
Figure 12 illustrates a top view of one embodiment of the preprocessed wafer, the phase change material layer, and insulation material after planarizing the additional insulation material layer.
Figure 13 illustrates a side cross-sectional view of one embodiment of the preprocessed wafer, the phase change material layer, and a dielectric material layer.
Figure 14 illustrates a top view of one embodiment of the preprocessed wafer, the phase change material, and dielectric material after etching the dielectric material layer to expose the preprocessed wafer and the phase change material.
Figure 15 illustrates a side cross-sectional view of one embodiment of the preprocessed wafer, the phase change material, the dielectric material, and an additional insulation material layer.
Figure 16 illustrates a top view of one embodiment of the preprocessed wafer, the phase change material, and insulation material after planarizing the additional insulation material layer.
Figure 17 illustrates a side cross-sectional view of one embodiment of the preprocessed wafer, the phase change material, the insulation material, and a dielectric material layer.
Figure 18 illustrates a top view of one embodiment of the preprocessed wafer, the phase change material, the insulation material, and a dielectric layer after etching the dielectric material layer.
Figure 19A illustrates a top view of one embodiment of a preprocessed wafer.
Figure 19B illustrates a side cross-sectional view of one embodiment of the preprocessed wafer.
Figure 20 illustrates a side cross-sectional view of one embodiment of the preprocessed wafer and a first phase change material layer.
Figure 21 illustrates a side cross-sectional view of one embodiment of the preprocessed wafer and a protective material.
Figure 22 illustrates a side cross-sectional view of one embodiment of the preprocessed wafer, the protective material, and the first phase change material layer.
Figure 23A illustrates a side cross-sectional view of one embodiment of the preprocessed wafer and multiple phase change portions.
Figure 23B illustrates a top view of one embodiment of the preprocessed wafer and the multiple phase change portions.
Figure 24 illustrates a top view of one embodiment of phase change portions after etching the phase change portions.
Figure 25A illustrates a side cross-sectional view of one embodiment of a phase change memory cell with multiple phase change material layers in a stack.
Figure 25B illustrates a side cross-sectional view of another embodiment of a phase change memory cell with multiple phase change material layers in a stack.
Figure 26A illustrates a top view of another embodiment of a phase change memory cell with multiple phase change material layers in a stack.
Figure 26B illustrates a top view of another embodiment of a phase change memory cell with multiple phase change material layers in a stack.

### Detailed Description

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments of the present invention can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

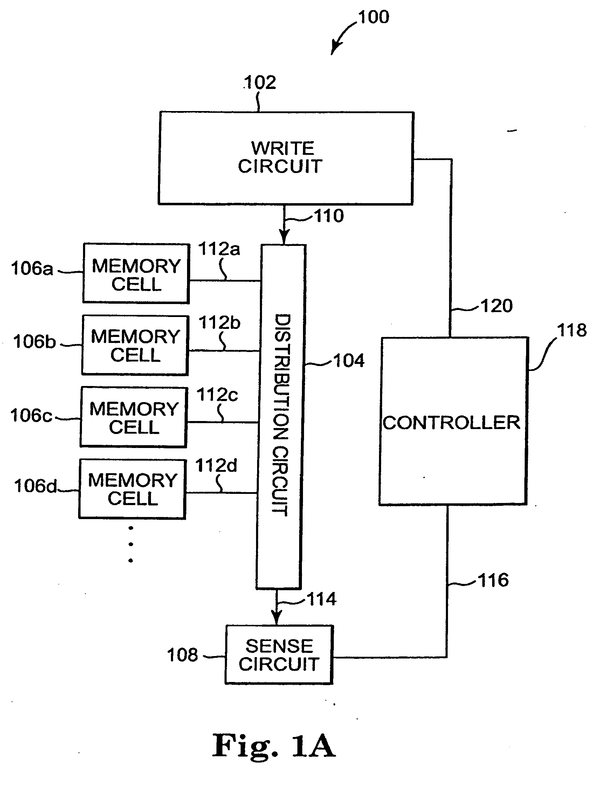

Figure 1A is a block diagram illustrating one embodiment of a memory device 100. Memory device 100 includes a write circuit 102, a distribution circuit 104, memory cells 106a, 106b, 106c, and 106d, a sense circuit 108, and a controller 118. Each of the memory cells 106a-106d is a phase change memory cell that stores data based on the amorphous and crystalline states of phase change material in the memory cell. Also, each of the memory cells 106a-106d can be programmed into one of more than two states by programming the phase change material to have intermediate resistance values. To program one of the memory cells 106a-106d to an intermediate resistance value, the amount of crystalline material coexisting with amorphous material - and hence the cell resistance - is controlled by controller 118 following a suitable write strategy.

As used herein, the term "electrically coupled" is not meant to mean that the elements must be directly coupled together and intervening elements may be provided between the « electrically coupled » elements.

Write circuit 102 is electrically coupled to distribution circuit 104 though signal path 110. Distribution circuit 104 is electrically coupled to each of the memory cells 106a-106d through signal paths 112a-112d. Distribution circuit 104 is electrically coupled to memory cell 106a through signal path 112a. Distribution circuit 104 is electrically coupled to memory cell 106b through signal path 112b. Distribution circuit 104 is electrically coupled to memory cell 106c through signal path 112c. Distribution circuit 104 is electrically coupled to memory cell 106d through signal path 112d. In addition, distribution circuit 104 is electrically coupled to sense circuit 108 through signal path 114, and sense circuit 108 is electrically coupled to controller 118 through signal path 116. Controller 118 is also electrically coupled to write circuit 102 through signal path 120.

Each of the memory cells 106a-106d includes a phase change material that may be changed from an amorphous state to a crystalline state or from a crystalline state to an amorphous state under the influence of temperature change. The amount of crystalline phase change material coexisting with amorphous phase change material in one of the memory cells 106a-106d thereby defines more than two states for storing data within memory device 100. Memory cells 106a-106d have a step-like programming characteristic to facilitate multi-bit data storage.

In one embodiment, each of the memory cells 106a-106d includes a planar or bridge structure. The planar or bridge structure includes a first electrode and a second electrode. The first electrode and the second electrode are located in a common horizontal plane and are separated by insulation material. A phase change material layer contacts and bridges the first electrode and the second electrode. Programming current passes through the phase change material horizontally from one electrode to the other electrode.

In one embodiment, a phase change material layer is formed over a preprocessed wafer. The preprocessed wafer includes a first electrode, a second electrode, and insulation material between the first and second electrodes. In one embodiment, the phase change material of each memory cell 106a-106d forms a step-like pattern to achieve a step-like programming characteristic. Each contiguous step in the pattern is surrounded by insulation material. In one embodiment, the surrounding insulation material includes low-k material.

When current is applied to the step-like pattern of phase change material, the current density through each step varies. The step having the narrowest cross-section provides the highest current density and the step having the widest cross-section provides the lowest current density. The step having the highest current density transitions from an amorphous state to a crystalline or from a crystalline state to an amorphous state before the step or steps providing lower current densities. The step having the highest current density transitions first since the temperature induced within the phase change material is greater within the step providing the highest current density. If a higher current is passed through the cell; the next narrowest step transitions states. In this way, a selected number of steps of phase change material in the step-like pattern are programmed to reliably and repeatably provide a specific resistance value.

In another embodiment, the phase change material layer includes a plurality of phase change materials serially arranged in the step-like pattern. Two or more of the plurality of phase change materials have different crystallization temperatures. By varying the crystallization temperature between the steps in the step-like pattern, the transition of each step is further controlled, such that a selected number of steps of phase change material in the step-like pattern are programmed to reliably and repeatably provide a specific resistance value.

In another embodiment, a plurality of phase change material layers are arranged in a stack. In one embodiment, the stack of phase change material layers forms a step-like pattern between the first and second electrodes. Two or more of the phase change material layers have different crystallization temperatures. By varying the crystallization temperature, the transition of each phase change material layer and/or the transition of each step in the step-like pattern is further controlled, such that a selected number of phase change material layers and/or steps of phase change material in the step-like pattern are programmed to reliably and repeatably provide a specific resistance value.

In another embodiment, a dielectric layer having a low thermal conductivity compared to the insulation material between the first and second electrodes contacts at least a portion of the phase change material layer or layers to vary the thermal environment between the steps in the step-like pattern. In one embodiment, the dielectric layer is a low-k material. By varying the thermal environment between the steps in the step-like pattern, the temperature induced within each step is further controlled, such that a selected number of steps of phase change material in the step-like pattern are programmed to reliably and repeatably provide a specific resistance value.

In the amorphous state, a phase change material exhibits significantly higher resistivity than in the crystalline state. Therefore, by controlling the amorphous and crystalline fractions of the phase change material, the more than two states of memory cells 106a-106d differ in their electrical resistivity. In one embodiment, the more than two states include three states and a trinary system is used, wherein the three states are assigned bit values of "0", "1", and "2". In another embodiment; the more than two states are four states that are assigned multi-bit values, such as "00", "01" "10", and "11". In other embodiments, the more than two states can be any suitable number of states in the phase change material of a memory cell.

Controller 118 controls the operation of write circuit 102 and sense circuit 108. Controller 118 includes a microprocessor, microcontroller, or other suitable logic circuitry for controlling the operation of write circuit 102 and sense circuit 108. Controller 118 controls write circuit 102 for setting the resistance states of memory cells 106a-106d. Controller 118 controls sense circuit 108 for reading the resistance states of memory cells 106a-106d.

In one embodiment, write circuit 102 provides voltage pulses to distribution circuit 104 through signal path 110, and distribution circuit 104 controllably directs the voltage pulses to memory cells 106a-106d through signal paths 112a-112d. In one embodiment, distribution circuit 104 includes a plurality of transistors that controllably direct voltage pulses to each of the memory cells 106a-106d. In other embodiments, write circuit 102 provides current pulses to distribution circuit 104 through signal path 110, and distribution circuit 104 controllably directs the current pulses to memory cells 106a-106d through signal paths 112a-112d.

Sense circuit 108 reads each of the more than two states of memory cells 106a-106d through signal path 114. Distribution circuit 104 controllably directs read signals between sense circuit 108 and memory cells 106a-106d through signal paths 112a-112d. In one embodiment, distribution circuit 104 includes a plurality of transistors that controllably direct read signals between sense circuit 108 and memory cells 106a-106d. In one embodiment, to read the resistance of one of the memory cells 106a-106d, sense circuit 108 provides current that flows through one of the memory cells 106a-106d and sense circuit 108 reads the voltage across that one of the memory cells 106a-106d. In one embodiment, sense circuit 108 provides voltage across one of the memory cells 106a-106d and reads the current that flows through that one of the memory cells 106a-106d. In one embodiment, write circuit 102 provides voltage across one of the memory cells 106a-106d and sense circuit 108 reads the current that flows through that one of the memory cells 106a-106d. In one embodiment, write circuit 102 provides current through one of the memory cells 106a-106d and sense circuit 108 reads the voltage across that one of the memory cells 106a-106d.

To program a memory cell 106a-106d within memory device 100, write circuit 102 generates a current or voltage pulse for heating the phase-change material in the target memory cell. In one embodiment, write circuit 102 generates an appropriate current or voltage pulse, which is fed into distribution circuit 104 and distributed to the appropriate target memory cell 106a-106d. The current or voltage pulse amplitude and duration are controlled by controller 118 depending on the specific state to which the target memory cell 106a-106d is being programmed. Generally, a "set" operation of a memory cell is heating the phase-change material of the target memory cell above its crystallization temperature (but below its melting temperature) long enough to achieve the crystalline state or a partially crystalline and partially amorphous state. Generally, a "reset" operation of a memory cell is heating the phase-change material of the target memory cell above its melting temperature, and then quickly quench cooling the material, thereby achieving the amorphous state or a partially amorphous and partially crystalline state. A memory cell can be programmed to a resistance state between an amorphous state and a crystalline state by applying a partial "set" or a partial "reset" pulse to the memory cell to provide amorphous and crystalline fractions of the phase change material.

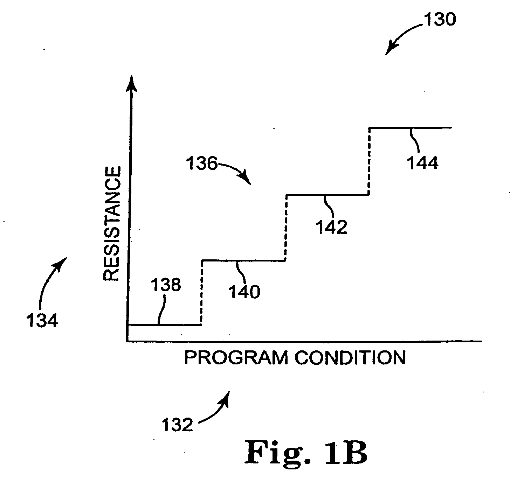

Figure 1B is a graph 130 illustrating one embodiment of a step-like programming characteristic 136 for phase change memory cells 106a-106d. Graph 130 includes program condition on x-axis 132 and resistance on y-axis 134. Suitable program parameters can include for example write time or pulse amplitude. Step-like programming characteristic 136 provides reduced variation of programmed resistance around a selected program condition. In one embodiment, a substantially constant resistance level or step is present at a selected program condition.

At a first program condition, a memory cell is programmed to a first resistance step or state as indicated at 138. In one embodiment, the step indicated at 138 is a "00" state. At a second program condition, a memory cell is programmed to a second resistance step or state as indicated at 140. The second resistance state is greater than the first resistance state. In one embodiment, the step indicated at 140 is a "01" state. At a third program condition, a memory cell is programmed to a third resistance step or state as indicated at 142. The third resistance state is greater than the second resistance state. In one embodiment, the step indicated at 142 is a "10" state. At a fourth program condition, a memory cell is programmed to a fourth resistance step or state as indicated at 144. The fourth resistance state is greater than the third resistance state. In one embodiment, the step indicated at 144 is a "11" state. In other embodiments, a memory cell can have any suitable step-like programming characteristic including any suitable number of resistance steps or states. The following embodiments of phase change memory cells provide a step-like programming characteristic.

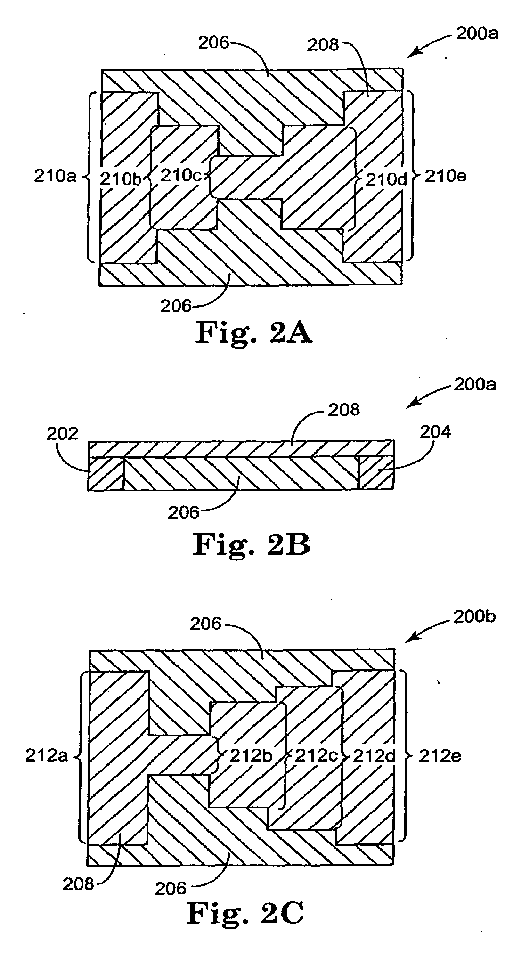

Figure 2A illustrates a top view of one embodiment of a phase change memory cell 200a. Figure 2B illustrates a side cross-sectional view of one embodiment of phase change memory cell 200a. In one embodiment, each of the memory cells 106a-106d is similar to phase change memory cell 200a. Phase change memory cell 200a includes a first electrode 202, a second electrode 204, insulation material 206, and phase change material 208. Phase change material 208 includes a first phase change portion 210a, a second phase change portion 210b, a third phase change portion 210c, a fourth phase change portion 210d, and a fifth phase change portion 210e.

In one embodiment, at least a portion of first electrode 202 and/or second electrode 204 is covered with phase change material 208. Insulation material 206 contacts first electrode 202, second electrode 204, and phase change material 208. Phase change material 208 provides a storage location for storing two bits of data. First phase change portion 210a contacts first electrode 202 and second phase change portion 210b. Second phase change portion 210b contacts third phase change portion 210c. Third phase change portion 210c contacts fourth phase change portion 210d. Fourth phase change portion 210d contacts fifth phase change portion 210e. Fifth phase change portion 210e contacts second electrode 204.

A first layer of phase change memory cell 200a includes first electrode 202, second electrode 204, and insulation material 206. In one embodiment, a second layer, which contacts the first layer, includes phase change material 208. Phase change material 208 contacts first and second electrodes 202 and 204. In other embodiments, a plurality of layers including any suitable number of phase change materials are formed over the first layer.

Phase change portions 210a-210e provide a step-like pattern defined by insulation material 206. Phase change portions 210a-210e provide distinct transitions between one phase change portion to another. Each phase change portion 210a-210e forms a substantially rectangular shape. First phase change portion 210a and fifth phase change portion 210e are substantially the same size. Second phase change portion 210b and fourth phase change portion 210d are substantially the same size. Phase change portions 210b and 210d have larger cross-sections parallel to electrodes 202 and 204 than third phase change portion 210c. Phase change portions 210a and 210e have larger cross-sections parallel to electrodes 202 and 204 than phase change portions 210b and 210d. Each phase change portion 210a-210e is substantially centered between the ends of electrodes 202 and 204.

Insulation material 206 can be any suitable insulator, such as SiO₂, fluorinated silica glass (FSG), boro-phosphorous silicate glass (BPSG), borosilicate glass (BSG), or low-k material. First electrode 202 and second electrode 204 can be any suitable electrode material, such as TiN, TaN, W, TiSiN, TiAIN, or TaAlN.

Phase change material 208 may be made up of a variety of materials in accordance with the present invention. Generally, chalcogenide alloys that contain one or more elements from group VI of the periodic table are useful as such materials. In one embodiment, phase change material 208 of memory cell 200a is made up of a chalcogenide compound material, such as GeSbTe, SbTe, GeTe, or AgInSbTe. In another embodiment, phase change material 208 is chalcogen free, such as GeSb, GaSb, InSb, or GeGaInSb. In other embodiments, phase change material 208 is made up of any suitable material including one or more of the elements Ge, Sb, Te, Ga, As, In, Se, and S.

A selection device such as an active device like a transistor or diode, may be electrically coupled to first electrode 202 or second electrode 204 to control the application of current or voltage pulses to the other of first electrode 202 or second electrode 204, and thus to phase change material 208, to set and reset phase change material 208. The current density through third phase change portion 210c is greater than the current density through phase change portions 210b and 210d since third phase change portion 210c has a narrower cross-section parallel to electrodes 202 and 204 than phase change portions 210b and 210d. The current density through phase change portions 210b and 210d is greater than the current density through phase change portions 210a and 210e since phase change portions 210b and 210d have narrower cross-sections parallel to electrodes 202 and 204 than phase change portions 210a and 210e. Thus, a current or voltage pulse having a lower amplitude and/or duration is used to program third phase change portion 210c than to program phase change portions 210b and 210d. Further, a current or voltage pulse having a lower amplitude and/or duration is used to program phase change portions 210b and 210d than to program phase change portions 210a and 210e.

During operation of phase change memory cell 200a, current or voltage pulses are applied between first electrode 202 and second electrode 204 to program phase change memory cell 200a. A first current or voltage pulse having a first amplitude and/or duration programs third phase change portion 210c without significantly affecting first, second, fourth, or fifth phase change portions 210a, 210b, 210d, and 210e. A second current or voltage pulse having a second amplitude and/or duration programs phase change portions 210b-210d without significantly affecting phase change portions 210a and 210e. The second amplitude and/or duration is greater than the first amplitude and/or duration. A third current or voltage pulse having a third amplitude and/or duration programs phase change portions 210a-210e. The third amplitude and/or duration is greater than the second amplitude and/or duration.

By selectively programming phase change portions 210a-210e, phase change memory cell 200a can be programmed to provide four states in phase change material 208. In one embodiment, in a first state, phase change portions 210a-210e are amorphous. In a second state, third phase change portion 210c is crystalline, and first, second; fourth, and fifth phase change portions 210a, 210b, 210d, and 210e are amorphous. In a third state, phase change portions 210b-210d are crystalline, and phase change portions 210a and 210e are amorphous. In a fourth state, phase change portions 210a-210e are crystalline.

In another embodiment, in a first state, phase change portions 210a-210e are crystalline. In a second state, third phase change portion 210c is amorphous, and first, second, fourth, and fifth phase change portions 210a, 210b, 210d, and 210e are crystalline. In a third state, phase change portions 210b-210d are amorphous, and phase change portions 210a and 210e are crystalline. In a fourth state, phase change portions 210a-210e are amorphous. In other embodiments, any suitable number of phase change step-like portions 210 are used for obtaining a desired number of states in phase change memory cell 200a.

Figure 2C illustrates a top view of another embodiment of a phase change memory cell 200b. In one embodiment, each of the memory cells 106a-106d is similar to phase change memory cell 200b. Phase change memory cell 200b is similar to phase change memory cell 200a previously described and illustrated with reference to Figure 2A, except that in phase change memory cell 200b phase change portions 210a-210e are replaced with phase change portions 212a-212e. Phase change material 208 includes a first phase change portion 212a, a second phase change portion 212b, a third phase change portion 212c, a fourth phase change portion 212d, and a fifth phase change portion 212e. First phase change portion 212a contacts first electrode 202 and second phase change portion 212b. Second phase change portion 212b contacts third phase change portion 212c. Third phase change portion 212c contacts fourth phase change portion 212d. Fourth phase change portion 212d contacts fifth phase change portion 212e. Fifth phase change portion 212e contacts second electrode 204.

Phase change portions 212a-212e provide a step-like pattern defined by insulation material 206. Phase change portions 212a-212e provide distinct transitions between one phase change portion to another. Each phase change portion 212a-212e forms a substantially rectangular shape. First phase change portion 212a and fifth phase change portion 212e are substantially the same size. Phase change portions 212a and 212e have larger cross-sections parallel to electrodes 202 and 204 than fourth phase change portion 212d. Fourth phase change portion 212d has a larger cross-section parallel to electrodes 202 and 204 than third phase change portion 212c. Third phase change portion 212c has a larger cross-section parallel to electrodes 202 and 204 than second phase change portion 212b. Each phase change portion 212a-212e is substantially centered between the ends of electrodes 202 and 204.

A selection device such as an active device like a transistor or diode, may be electrically coupled to first electrode 202 or second electrode 204 to control the application of current or voltage pulses to the other of first electrode 202 or second electrode 204, and thus to phase change material 208, to set and reset phase change material 208. The current density through second phase change portion 212b is greater than the current density through third phase change portion 212c since second phase change portion 212b has a narrower cross-section parallel to electrodes 202 and 204 than third phase change portion 212c. The current density through third phase change portion 212c is greater than the current density through fourth phase change portion 212d since third phase change portion 212c has a narrower cross-section parallel to electrodes 202 and 204 than fourth phase change portion 212d. Thus, a current or voltage pulse having a lower amplitude and/or duration is used to program second phase change portion 212b than to program third phase change portion 212c. Further, a current or voltage pulse having a lower amplitude and/or duration is used to program third phase change portion 212c than to program fourth phase change portion 212d.

During operation of phase change memory cell 200b, current or voltage pulses are applied between first electrode 202 and second electrode 204 to program phase change memory cell 200b. A first current or voltage pulse having a first amplitude and/or duration programs second phase change portion 212b without significantly affecting first, third, fourth, or fifth phase change portions 212a, 212c, 212d, and 212e. A second current or voltage pulse having a second amplitude and/or duration programs phase change portions 212b and 212c without significantly affecting first, fourth, or fifth phase change portions 212a, 212d, and 212e. The second amplitude and/or duration is greater than the first amplitude and/or duration. A third current or voltage pulse having a third amplitude and/or duration programs phase change portions 212b-212d without significantly affecting first and fifth phase change portions 212a and 212e. The third amplitude and/or duration is greater than the second amplitude and/or duration.

By selectively programming phase change portions 212b-212d, phase change memory cell 200b can be programmed to provide four states in phase change material 208. In one embodiment, in a first state, phase change portions 212b-212d are amorphous. In a second state, second phase change portion 212b is crystalline, and phase change portions 212c and 212d are amorphous. In a third state, phase change portions 212b and 212c are crystalline, and fourth phase change portion 212d is amorphous. In a fourth state, phase change portions 212b-212d are crystalline.

In another embodiment, in a first state, phase change portions 2.12b-21.2d are crystalline. In a second state, second phase change portion 212b is amorphous, and phase change portions 212c and 212d are crystalline. In a third state, phase change portions 212b and 212c are amorphous, and fourth phase change portion 212d is crystalline. In a fourth state, phase change portions 212b-212d are amorphous. In other embodiments, any suitable number of phase change step-like portions 212 are used for obtaining a desired number of states in phase change memory cell 200b.

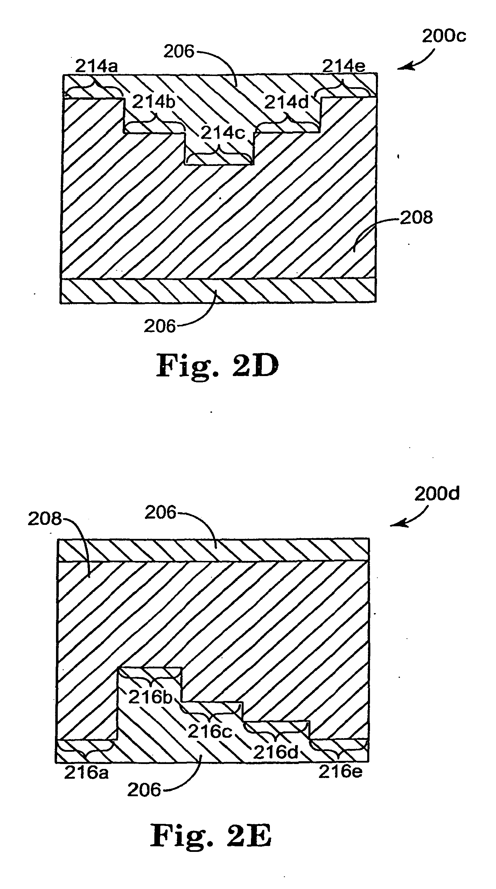

Figure 2D illustrates a top view of another embodiment of a phase change memory cell 200c. In one embodiment, each of the memory cells 106a-106d is similar to phase change memory cell 200c. Phase change memory cell 200c is similar to phase change memory cell 200a previously described and illustrated with reference to Figure 2A, except that in phase change memory cell 200c phase change portions 210a-210e are replaced with phase change portions 214a-214e. Phase change material 208 includes a first phase change portion 214a, a second phase change portion 214b, a third phase change portion 214c, a fourth phase change portion 214d, and a fifth phase change portion 214e. First phase change portion 214a contacts first electrode 202 and second phase change portion 214b. Second phase change portion 214b contacts third phase change portion 214c. Third phase change portion 214c contacts fourth phase change portion 214d. Fourth phase change portion 214d contacts fifth phase change portion 212e. Fifth phase change portion 212e contacts second electrode 204.

Phase change portions 214a-214e provide a step-like pattern defined by insulation material 206. Phase change portions 214a-214e provide distinct transitions between one phase change portion to another. Each phase change portion 214a-214e forms a substantially rectangular shape. First phase change portion 214a and fifth phase change portion 214e are substantially the same size. Second phase change portion 214b and fourth phase change portion 214d are substantially the same size. Phase change portions 214b and 214d have larger cross-sections parallel to electrodes 202 and 204 than third phase change portion 214c. Phase change portions 214a and 214e have larger cross-sections parallel to electrodes 202 and 204 than phase change portions 214b and 214d. Each phase change portion 214a-214e is substantially aligned with one end of electrodes 202 and 204.

A selection device such as an active device like a transistor or diode, may be electrically coupled to first electrode 202 or second electrode 204 to control the application of current or voltage pulses to the other of first electrode 202 or second electrode 204; and thus to phase change material 208, to set and reset phase change material 208. The current density through third phase change portion 214c is greater than the current density through phase change portions 214b and 214d since third phase change portion 214c has a narrower cross-section parallel to electrodes 202 and 204 than phase change portions 214b and 214d. The current density through phase change portions 214b and 214d is greater than the current density through phase change portions 214a and 214e since phase change portions 214b and 214d have a narrower cross-section parallel to electrodes 202 and 204 than phase change portions 214a and 214e. Thus, a current or voltage pulse having a lower amplitude and/or duration is used to program third phase change portion 214c than to program phase change portions 214b and 214d. Further, a current or voltage pulse having a lower amplitude and/or duration is used to program phase change portions 214b and 214d than to program phase change portions 214a and 214e.

During operation of phase change memory cell 200c, current or voltage pulses are applied between first electrode 202 and second electrode 204 to program phase change memory cell 200c. A first current or voltage pulse having a first amplitude and/or duration programs third phase change portion 214c without significantly affecting first, second, fourth or fifth phase change portions 214a, 214b, 214d, and 214e. A second current or voltage pulse having a second amplitude and/or duration programs phase change portions 214b-214d without significantly affecting phase change portions 214a and 214e. The second amplitude and/or duration is greater than the first amplitude and/or duration. A third current or voltage pulse having a third amplitude and/or duration programs phase change portions 214a-214e. The third amplitude and/or duration is greater than the second amplitude and/or duration.

By selectively programming phase change portions 214a-214e, phase change memory cell 200c can be programmed to provide four states in phase change material 208. In one embodiment, in a first state, phase change portions 214a-214e are amorphous. In a second state, third phase change portion 214c is crystalline, and first, second, fourth, and fifth phase change portions 214a, 214b, 214d, and 214e are amorphous. In a third state, phase change portions 214b-214d are crystalline, and phase change portions 214a and 214e are amorphous. In a fourth state, phase change portions 214a-214e are crystalline.

In another embodiment, in a first state, phase change portions 214a-214e are crystalline. In a second state, third phase change portion 214c is amorphous, and first, second, fourth, and fifth phase change portions 214a, 214b, 214d, and 214e are crystalline. In a third state, phase change portions 214b-214d are amorphous, and phase change portions 214a and 214e are crystalline. In a fourth state, phase change portions 214a-214e are amorphous. In other embodiments, any suitable number of phase change step-like portions 214 are used for obtaining a desired number of states in phase change memory cell 200c.

Figure 2E illustrates a top view of another embodiment of a phase change memory cell 200d. In one embodiment, each of the memory cells 106a-106d is similar to phase change memory cell 200d. Phase change memory cell 200d is similar to phase change memory cell 200a previously described and illustrated with reference to Figure 2A, except that in phase change memory cell 200c phase change portions 210a-210e are replaced with phase change portions 216a-216e. Phase change material 208 includes a first phase change portion 216a, a second phase change portion 216b, a third phase change portion 216c, a fourth phase change portion 216d, and a fifth phase change portion 216e. First phase change portion 216a contacts first electrode 202 and second phase change portion 216b. Second phase change portion 216b contacts third phase change portion 216c. Third phase change portion 216c contacts fourth phase change portion 216d. Fourth phase change portion 216d contacts fifth phase change portion 216e. Fifth phase change portion 216e contacts second electrode 204.

Phase change portions 216a-216e provide a step-like pattern defined by insulation material 206. Phase change portions 216a-216e provide distinct transitions between one phase change portion to another. Each phase change portion 216a-216e forms a substantially rectangular shape. First phase change portion 216a and fifth phase change portion 216e are substantially the same size. Phase change portions 216a and 216e have a larger cross-section parallel to electrodes 202 and 204 than fourth phase change portion 216d. Fourth phase change portion 216d has a larger cross-section parallel to electrodes 202 and 204 than third phase change portion 216c. Third phase change portion 216c has a larger cross-section than second phase change portion 216b. Each phase change portion 216a-216e is substantially aligned with one end of electrodes 202 and 204.

A selection device such as an active device like a transistor or diode, is electrically coupled to first electrode 202 or second electrode 204 to control the application of current or voltage pulses to the other of first electrode 202 or second electrode 204, and thus to phase change material 208, to set and reset phase change material 208. The current density through second phase change portion 216b is greater than the current density through third phase change portion 216c since third phase change portion 216b has a narrower cross-section parallel to electrodes 202 and 204 than third phase change portion 216c. The current density through third phase change portion 216c is greater than the current density through fourth phase change portion 216d since third phase change portion 216c has a narrower cross-section parallel to electrodes 202 and 204 than fourth phase change portion 216d. Thus, a current or voltage pulse having a lower amplitude and/or duration is used to program second phase change portion 216b than to program third phase change portion 216c. Further, a current or voltage pulse having a lower amplitude and/or duration is used to program third phase change portion 216c than to program fourth phase change portion 216d.

During operation of phase change memory cell 200d, current or voltage pulses are applied between first electrode 202 and second electrode 204 to program phase change memory cell 200d. A first current or voltage pulse having a first amplitude and/or duration programs second phase change portion 216b without significantly affecting first, third, fourth, or fifth phase change portions 216a, 216b, 216d, and 216e. A second current or voltage pulse having a second amplitude and/or duration programs phase change portions 216b and 216c without significantly affecting first, fourth and fifth phase change portions 216a, 216d, and 216e. The second amplitude and/or duration is greater than the first amplitude and/or duration. A third current or voltage pulse having a third amplitude and/or duration programs phase change portions 216b-216d without significantly affecting phase change portions 216a and 216e. The third amplitude and/or duration is greater than the second amplitude and/or duration.

By selectively programming phase change portions 216b-216d, phase change memory cell 200d can be programmed to provide four states in phase change material 208. In one embodiment, in a first state, phase change portions 216b-216d are amorphous. In a second state, second phase change portion 216b is crystalline, and phase change portions 216c and 216d are amorphous. In a third state, phase change portions 216b and 216c are crystalline, and fourth phase change portion 216d is amorphous. In a fourth state, phase change portions 216b-216d are crystalline.

In another embodiment, in a first state, phase change portions 216b-216d are crystalline. In a second state, second phase change portion 216b is amorphous, and phase change portions 216c and 216d are crystalline. In a third state, phase change portions 216b and 216c are amorphous, and fourth phase change portion 216d is crystalline. In a fourth state, phase change portions 216b-216d are amorphous. In other embodiments, any suitable number of phase change step-like portions 216 are used for obtaining a desired number of states in phase change memory cell 200d.

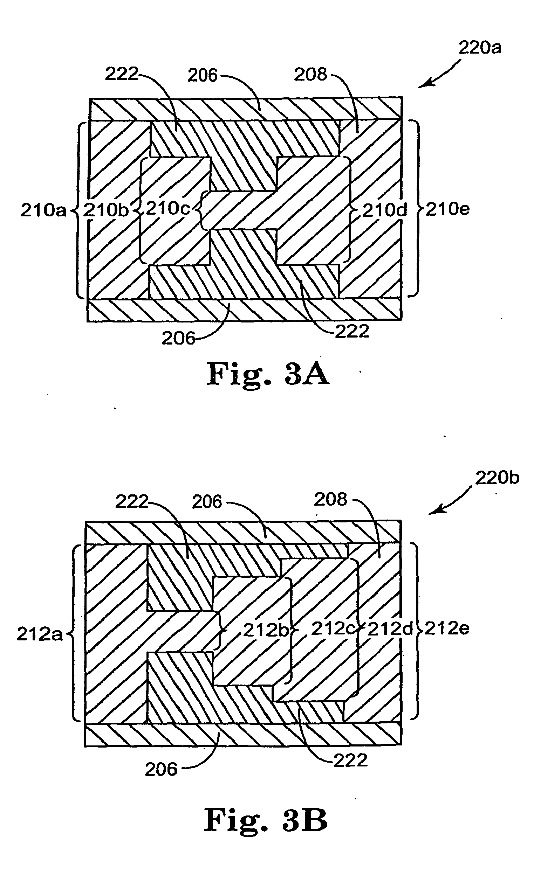

Figure 3A illustrates a top view of another embodiment of a phase change memory cell 220a. In one embodiment, each of the memory cells 106a-106d is similar to phase change memory cell 220a. Phase change memory cell 220a is similar to phase change memory cell 200a previously described and illustrated with reference to Figure 2A, except that phase change memory cell 220a includes dielectric material 222. Dielectric material 222 includes any suitable dielectric material, such as low-k material.

Dielectric material 222 contacts insulation material 206 and phase change material 208. Dielectric material 222 surrounds the step-like pattern provided by phase change portions 210b-210d, and varies the thermal environment of phase change portions 210b-210d. In one embodiment, dielectric material 222 has a lower thermal conductivity than insulation material 206. By varying the thermal environment of phase change portions 210b-210d, the temperature induced within each phase change portion 210b-210d is further controlled during programming. Phase change memory cell 220a operates similarly to phase change memory cell 200a previously described and illustrated with reference to Figure 2A.

Figure 3 B illustrates a top view of another embodiment of a phase change memory cell 220b. In one embodiment, each of the memory cells 106a-106d is similar to phase change memory cell 220b. Phase change memory cell 220b is similar to phase change memory cell 200b previously described and illustrated with reference to Figure 2C, except that phase change memory cell 220b includes dielectric material 222. Dielectric material 222 includes any suitable dielectric material, such as low-k material.

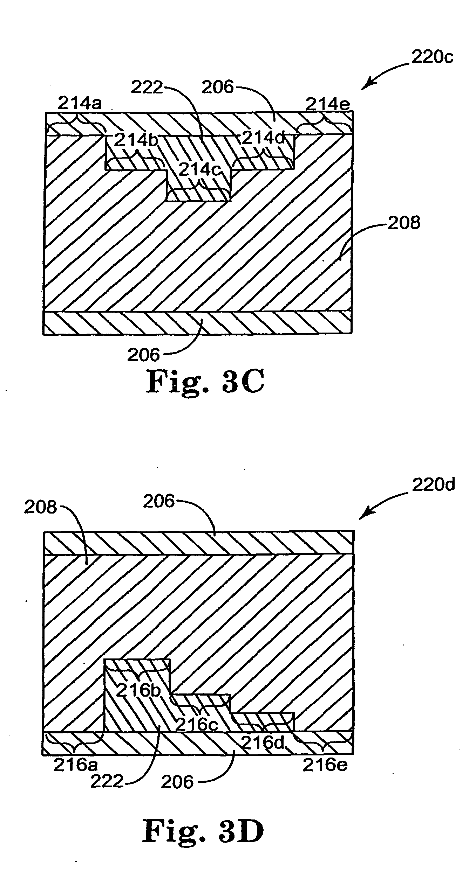

Dielectric material 222 contacts insulation material 206 and phase change material 208. Dielectric material 222 surrounds the step-like pattern provided by phase change portions 212b-212d, and varies the thermal environment of phase change portions 212b-212d. In one embodiment, dielectric material 222 has a lower thermal conductivity than insulation material 206. By varying the thermal environment of phase change portions 212b-212d, the temperature induced within each phase change portion 212b-212d is further controlled during programming. Phase change memory cell 220b operates similarly to phase change memory cell 200b previously described and illustrated with reference to Figure 2C. Figure 3C illustrates a top view of another embodiment of a phase change memory cell 220c. In one embodiment, each of the memory cells 106a-106d is similar to phase change memory cell 220c. Phase change memory cell 220c is similar to phase change memory cell 200c previously described and illustrated with reference to Figure 2D, except that phase change memory cell 220c includes dielectric material 222. Dielectric material 222 includes any suitable dielectric material, such as low-k material.

Dielectric material 222 contacts insulation material 206 and phase change material 208. Dielectric material 222 contacts the step-like pattern provided by phase change portions 214b-214d, and varies the thermal environment of phase change portions 214b-214d. In one embodiment, dielectric material 222 has a lower thermal conductivity than insulation material 206. By varying the thermal environment of phase change portions 214b-214d, the temperature induced within each phase change portion 214b-214d is further controlled during programming. Phase change memory cell 220c operates similarly to phase change memory cell 200c previously described and illustrated with reference to Figure 2D.

Figure 3D illustrates a top view of another embodiment of a phase change memory cell 220d. In one embodiment, each of the memory cells 106a-106d is similar to phase change memory cell 220d. Phase change memory cell 220d is similar to phase change memory cell 200d previously described and illustrated with reference to Figure 2E, except that phase change memory cell 220d includes dielectric material 222. Dielectric material 222 includes any suitable dielectric material, such as low-k material.

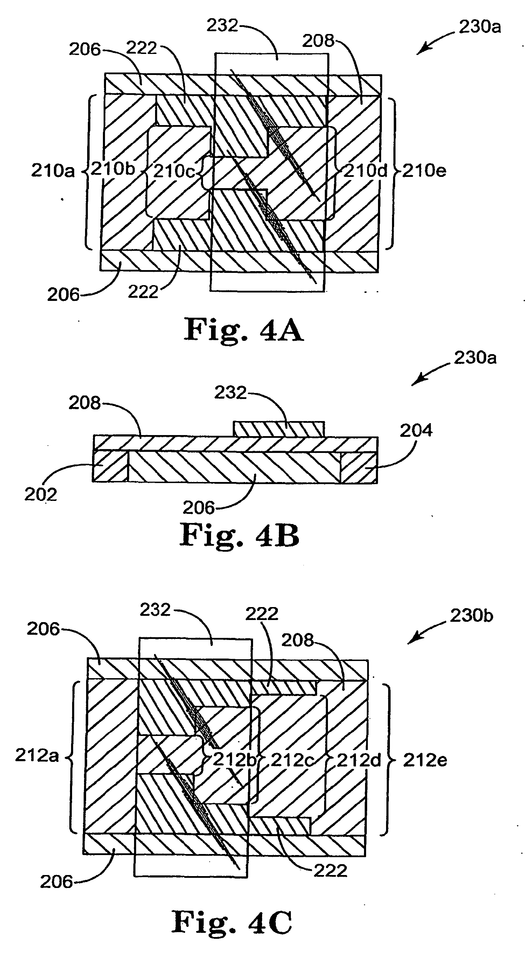

Dielectric material 222 contacts insulation material 206 and phase change material 208. Dielectric material 222 contacts the step-like pattern provided by phase change portions 216b-216d, and varies the thermal environment of phase change portions 216b-216d. In one embodiment, dielectric material 222 has a lower thermal conductivity than insulation material 206. By varying the thermal environment of phase change portions 216b-216d, the temperature induced within each phase change portion 216b-216d is further controlled during programming. Phase change memory cell 220d operates similarly to phase change memory cell 200d previously described and illustrated with reference to Figure 2E. Figure 4A illustrates a top view of another embodiment of a phase change memory cell 230a. Figure 4B illustrates a side cross-sectional view of one embodiment of phase change memory cell 230a. In one embodiment, each of the memory cells 106a-106d is similar to phase change memory cell 230a. Phase change memory cell 230a is similar to phase change memory cell 220a previously described and illustrated with reference to Figure 3A, except that phase change memory cell 230a includes dielectric layer 232. Dielectric layer 232 includes any suitable dielectric material, such as low-k material.

Dielectric layer 232 contacts the tops of third phase change portion 210c and fourth phase portion 210d, and varies the thermal environment of third phase change portion 210c and fourth phase change portion 210d. In one embodiment, dielectric layer 232 has a lower thermal conductivity than insulation material 206. By varying the thermal environment of phase change portions 210c and 210d, the temperature induced within each phase change portion 210c and 210d is further controlled during programming.

A selection device such as an active device like a transistor or diode, may be coupled to first electrode 202 or second electrode 204 to control the application of current or voltage pulses to the other of first electrode 202 or second electrode 204; and thus to phase change material 208, to set and reset phase change material 208. The current density through third phase change portion 210c is greater than the current density through phase change portions 210b and 210d since third phase change portion 210c has a narrower cross-section parallel to electrodes 202 and 204 than phase change portions 210b and 210d. The current density through second phase change portion 210b is substantially similar to the current density through fourth phase change portion 210d. Fourth phase change portion 210d, however, retains more heat than second phase change portion 210b since fourth phase change portion 210d contacts dielectric layer 232. In other embodiments, any suitable size of dielectric layer 232 contacting any suitable number of phase change step-like portions 210 is used for obtaining a desired number of states in phase change memory cell 230a.

During operation of phase change memory cell 230a, current or voltage pulses are applied between first electrode 202 and second electrode 204 to program phase change memory cell 230a. A first current or voltage pulse having a first amplitude and/or duration programs third phase change portion 210c without significantly affecting second or fourth phase change portions 210b and 210d. A second current or voltage pulse having a second amplitude and/or duration programs phase change portions 210c and 210d without significantly affecting second phase change portions 210b. The second amplitude and/or duration is greater than the first amplitude and/or duration. A third current or voltage pulse having a third amplitude and/or duration programs phase change portions 210b-210d. The third amplitude and/or duration is greater than the second amplitude and/or duration.

By selectively programming phase change portions 210b-210d, phase change memory cell 230a can be programmed to provide four states in phase change material 208. In one embodiment, in a first state, phase change portions 210b-210d are amorphous. In a second state, third phase change portion 210c is crystalline, and phase change portions 210b and 210d are amorphous. In a third state, phase change portions 210c and 210d are crystalline, and second phase change portion 210b is amorphous. In a fourth state, phase change portions 210b-210d are crystalline.

In another embodiment, in a first state, phase change portions 210b-210d are crystalline. In a second state, third phase change portion 210c is amorphous, and phase change portions 210b and 210d are crystalline. In a third state, phase change portions 210c and 210d are amorphous, and second phase change portion 210b is crystalline. In a fourth state, phase change portions 210b-210d are amorphous. In other embodiments, any suitable number of phase change step-like portions 210 are used for obtaining a desired number of states in phase change memory cell 230a.

Figure 4C illustrates a top view of another embodiment of a phase change memory cell 230b. In one embodiment, each of the memory cells 106a-106d is similar to phase change memory cell 230b. Phase change memory cell 230b is similar to phase change memory cell 220b previously described and illustrated with reference to Figure 3B, except that phase change memory cell 230b includes dielectric layer 232. Dielectric layer 232 includes any suitable dielectric material, such as low-k material. Dielectric layer 232 contacts the tops of second phase change portion 212b and third phase change portion 212c, and varies the thermal environment of second phase change portion 212b and third phase change portion 212c. In one embodiment, dielectric layer 232 has a lower thermal conductivity than insulation material 206. By varying the thermal environment of phase change portions 210b and 210c, the temperature induced within each phase change portion 210b and 210c is further controlled during programming. Phase change memory cell 230b operates similarly to phase change memory cell 200b previously described and illustrated with reference to Figure 2C.

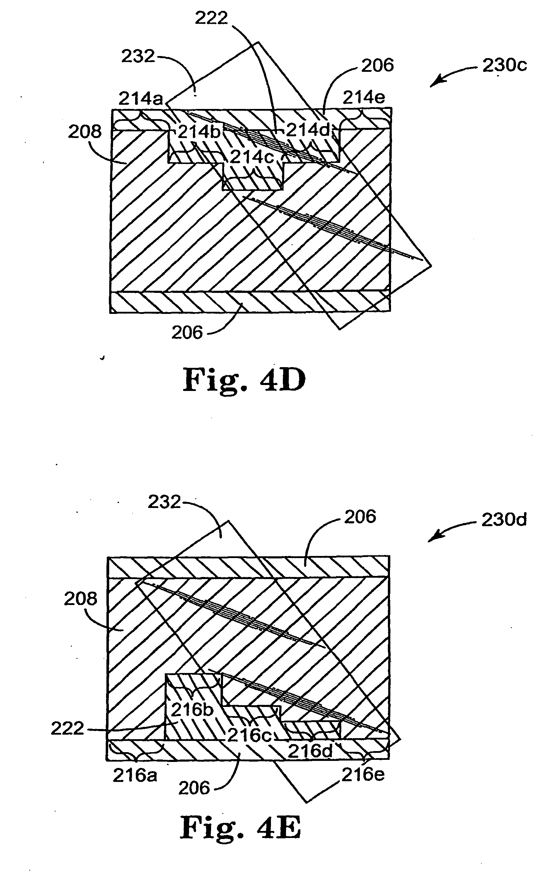

Figure 4D illustrates a top view of another embodiment of a phase change memory cell 230c. In one embodiment, each of the memory cells 106a-106d is similar to phase change memory cell 230c. Phase change memory cell 230c is similar to phase change memory cell 220c previously described and illustrated with reference to Figure 3C, except that phase change memory cell 230c includes dielectric layer 232. Dielectric layer 232 includes any suitable dielectric material, such as low-k material.

Dielectric layer 232 contacts the top of fourth phase change portion 214d and portions of the tops of second phase change portion 214b and third phase change portion 214c. Dielectric layer 232 varies the thermal environment of phase change portions 214b-214d. In one embodiment, dielectric layer 232 has a lower thermal conductivity than insulation material 206. By varying the thermal environment of phase change portions 214b-214d, the temperature induced within each phase change portion 214b-214d may be further controlled during programming.

A selection device such as an active device like a transistor or diode, is coupled to first electrode 202 or second electrode 204 to control the application of current or voltage pulses to the other of first electrode 202 or second electrode 204, and thus to phase change material 208, to set and reset phase change material 208. The current density through fourth phase change portion 214d is substantially the same as the current density through second phase change portion 214b. Fourth phase change portion 214d, however, retains more heat than second phase change portion 214b since fourth phase change portion 214d contacts much more of dielectric layer 232. In other embodiments, any suitable size of dielectric layer 232 contacting any suitable number of phase change step-like portions 214 is used for obtaining a desired number of states in phase change memory cell 230c.

During operation of phase change memory cell 230c, current or voltage pulses are applied between first electrode 202 and second electrode 204 to program phase change memory cell 230c. A first current or voltage pulse having a first amplitude and/or duration programs third phase change portion 214c without significantly affecting second or fourth phase change portions 214b and 214d. A second current or voltage pulse having a second amplitude and/or duration programs phase change portions 214c and 214d without significantly affecting second phase change portion 214b. The second amplitude and/or duration is greater than the first amplitude and/or duration. A third current or voltage pulse having a third amplitude and/or duration programs phase change portions 214b-214d. The third amplitude and/or duration is greater than the second amplitude and/or duration.

By selectively programming phase change portions 214b-214d, phase change memory cell 230c can be programmed to provide four states in phase change material 208. In one embodiment, in a first state, phase change portions 214b-214d are amorphous. In a second state, third phase change portion 214c is crystalline, and second and fourth phase change portions 214b and 214d are amorphous. In a third state, phase change portions 214c and 214d are crystalline, and second phase change portion 238c is amorphous. In a fourth state, phase change portions 214b-214d are crystalline.

In another embodiment, in a first state, phase change portions 214b-214d are crystalline. In a second state, third phase change portion 214c is amorphous, and second and fourth phase change portions 214b and 214d are crystalline. In a third state, phase change portions 214c and 214d are amorphous, and second phase change portion 214b is crystalline. In a fourth state, phase change portions 214b-214d are amorphous. In other embodiments, any suitable number of phase change step-like portions 214 are used for obtaining a desired number of states in phase change memory cell 230c.

Figure 4E illustrates a top view of another embodiment of a phase change memory cell 230d. In one embodiment, each of the memory cells 106a-106d is similar to phase change memory cell 230d. Phase change memory cell 230c is similar to phase change memory cell 220d previously described and illustrated with reference to Figure 3D, except that phase change memory cell 230d includes dielectric layer 232. Dielectric layer 232 includes any suitable dielectric material, such as low-k material.

Dielectric layer 232 contacts the tops of third phase change portion 216c and portions of the tops of second phase change portion 216b and fourth phase change portion 216d. Dielectric layer 232 varies the thermal environment of phase change portions 216b-216d. In one embodiment, dielectric layer 232 has a lower thermal conductivity than insulation material 206. By varying the thermal environment of phase change portions 216b-216d, the temperature induced within each phase change portion 216b-216d is further controlled during programming. Phase change memory cell 230d operates similarly to phase change memory cell 200d previously described and illustrated with reference to Figure 2E.

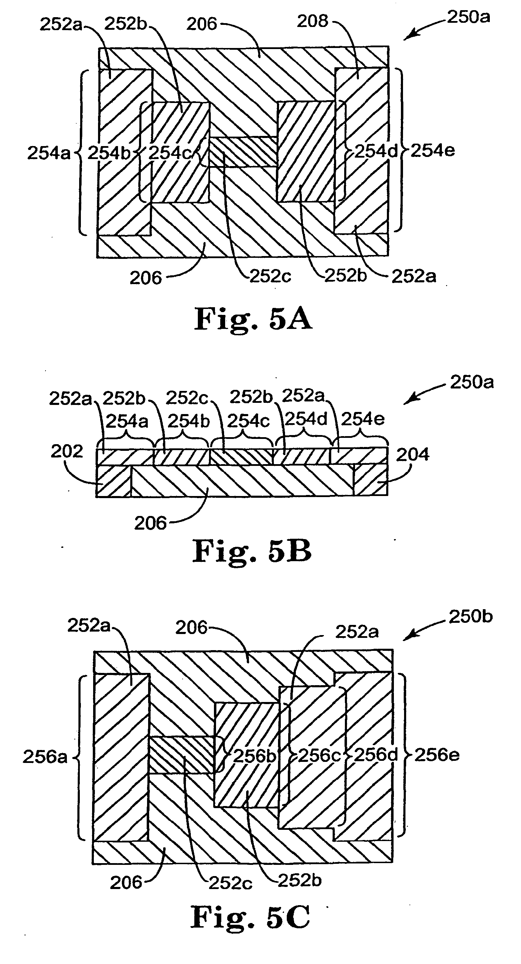

Figure 5A illustrates a top view of another embodiment of a phase change memory cell 250a. Figure 5B illustrates a side cross-sectional view of one embodiment of phase change memory cell 250a. In one embodiment, each of the memory cells 106a-106d is similar to phase change memory cell 250a. Phase change memory cell 250a is similar to phase change memory cell 200a previously described and illustrated with reference to Figure 2A, except that in phase change memory cell 250a phase change material 208 is replaced with phase change materials 252a-252c and phase change portions 210a-210e are replaced with phase change portions 254a-254e.

First phase change portion 254a and fifth phase change portion 254e include a first phase change material 252a. Second phase change portion 254b and fourth phase change portion 254d include a second phase change material 252b. Third phase change portion 254c includes a third phase change material 252c. In other embodiments, any suitable number of phase change materials 252 are used in conjunction with any suitable number of change portions 254 for obtaining a desired number of states in phase change memory cell 250a.

At least two of the phase change materials 252a-252c have different crystallization temperatures. By varying the crystallization temperature between the phase change portions 254a-254e, the transition of each phase change portion 254a-254e is further controlled during programming. Phase change memory cell 250a operates similarly to phase change memory cell 200a previously described and illustrated with reference to Figure 2A.

Figure 5C illustrates a top view of another embodiment of a phase change memory cell 250b. In one embodiment, each of the memory cells 106a-106d is similar to phase change memory cell 250b. Phase change memory cell 250b is similar to phase change memory cell 200b previously described and illustrated with reference to Figure 2C, except that in phase change memory cell 250b phase change material 208 is replaced with phase change materials 252a-252c and phase change portions 212a-212e are replaced with phase change portions 256a-256e.

First phase change portion 256a, fourth phase change portion 256d, and fifth phase change portion 256e include a first phase change material 252a. Third phase change portion 256c includes a second phase change material 252b. Second phase change portion 256b includes a third phase change material 252c. In other embodiments, any suitable number of phase change materials 252 are used in conjunction with any suitable number of phase change portions 256 for obtaining a desired number of states in phase change memory cell 250b.

At least two of the phase change materials 252a-252c have different crystallization temperatures. By varying the crystallization temperature between the phase change portions 256a-256e, the transition of each phase change portion 256a-256e is further controlled during programming. Phase change memory cell 250b operates similarly to phase change memory cell 200b previously described and illustrated with reference to Figure 2C.

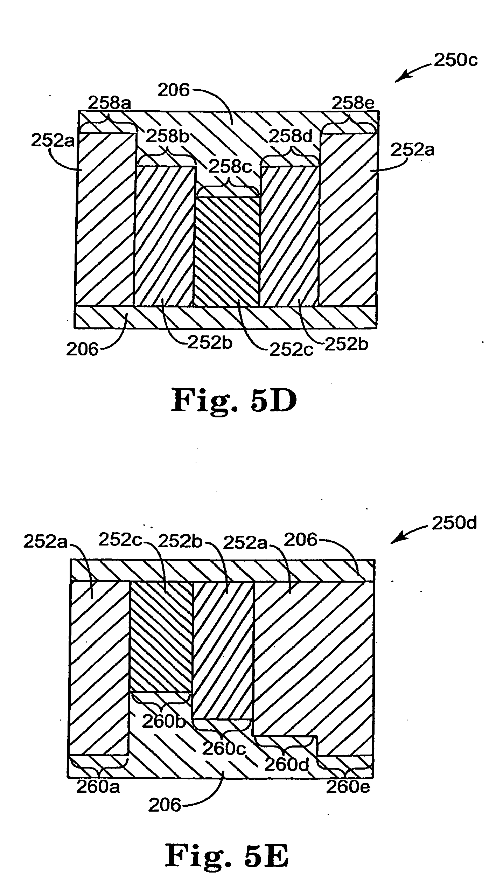

Figure 5D illustrates a top view of another embodiment of a phase change memory cell 250c. In one embodiment, each of the memory cells 106a-106d is similar to phase change memory cell 250c. Phase change memory cell 250c is similar to phase change memory cell 200c previously described and illustrated with reference to Figure 2D, except that in phase change memory cell 250c phase change material 208 is replaced with phase change materials 252a-252c and phase change portions 214a-214e are replaced with phase change portions 258a-258e. First phase change portion 258a and fifth phase change portion 258e include a first phase change material 252a. Second phase change portion 258b and fourth phase change portion 258d include a second phase change material 252b. Third phase change portion 258c includes a third phase change material 252c. In other embodiments, any suitable number of phase change materials 252 are used in conjunction with any suitable number of phase change portions 258 for obtaining a desired number of states in phase change memory cell 250c.

At least two of phase change materials 252a-252c have different crystallization temperatures. By varying the crystallization temperature between the phase change portions 258a-258e, the transition of each phase change portion 258a-258e is further controlled during programming. Phase change memory cell 250c operates similarly to phase change memory cell 200c previously described and illustrated with reference to Figure 2D.

Figure 5E illustrates a top view of another embodiment of a phase change memory cell 250d. In one embodiment, each of the memory cells 106a-106d is similar to phase change memory cell 250d. Phase change memory cell 250d is similar to phase change memory cell 200d previously described and illustrated with reference to Figure 2E, except that in phase change memory cell 250d phase change material 208 is replaced with phase change materials 252a-252c and phase change portions 216a-216e are replaced with phase change portions 260a-260e. First phase change portion 260a, fourth phase change portion 260d, and fifth phase change portion 260e include a first phase change material 252a. Third phase change portion 260c includes a second phase change material 252b. Second phase change portion 260b includes a third phase change material 252c. In other embodiments, any suitable number of phase change materials 252 are used in conjunction with any suitable number of phase change portions 260 for obtaining a desired number of states in phase change memory cell 250c.

At least two of the phase change materials 252a-252c have different crystallization temperatures. By varying the crystallization temperature between the phase change portions 260a-260e, the transition of each phase change portion 260a-260e is further controlled during programming. Phase change memory cell 250d operates similarly to phase change memory cell 200d previously described and illustrated with reference to Figure 2E.

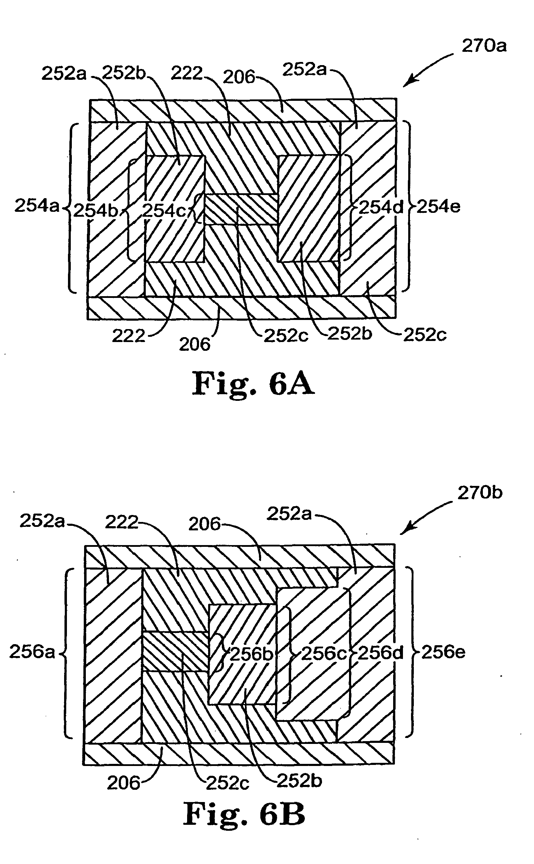

Figure 6A illustrates a top view of another embodiment of a phase change memory cell 270a. In one embodiment, each of the memory cells 106a-106d is similar to phase change memory cell 270a. Phase change memory cell 270a is similar to phase change memory cell 250a previously described and illustrated with reference to Figure 5A, except that phase change memory cell 270a includes dielectric material 222. Dielectric material 222 includes any suitable dielectric material, such as low-k material.

Dielectric material 222 contacts insulation material 206 and phase change materials 252a-252c. Dielectric material 222 surrounds the sides of the step-like pattern provided by phase change portions 254b-254d, and varies the thermal environment of phase change portions 254b-254d. In one embodiment, dielectric material 222 has a lower thermal conductivity than insulation material 206. By varying the thermal environment of phase change portions 254b-254d, the temperature induced within each phase change portion 254b-254d is further controlled during programming. Phase change memory cell 270a operates similarly to phase change memory cell 200a previously described and illustrated with reference to Figure 2A.

Figure 6B illustrates a top view of another embodiment of a phase change memory cell 270b. In one embodiment, each of the memory cells 106a-106d is similar to phase change memory cell 270b. Phase change memory cell 270b is similar to phase change memory cell 250b previously described and illustrated with reference to Figure 5C, except that phase change memory cell 270b includes dielectric material 222. Dielectric material 222 includes any suitable dielectric material, such as low-k material.

Dielectric material 222 contacts insulation material 206 and phase change materials 252a-252c. Dielectric material 222 surrounds the sides of the step-like pattern provided by phase change portions 256b-256d, and varies the thermal environment of phase change portions 256b-256d. In one embodiment, dielectric material 222 has a lower thermal conductivity than insulation material 206. By varying the thermal environment of phase change portions 256b-256d, the temperature induced within each phase change portion 256b-256d is further controlled during programming. Phase change memory cell 270b operates similarly to phase change memory cell 200b previously described and illustrated with reference to Figure 2C.

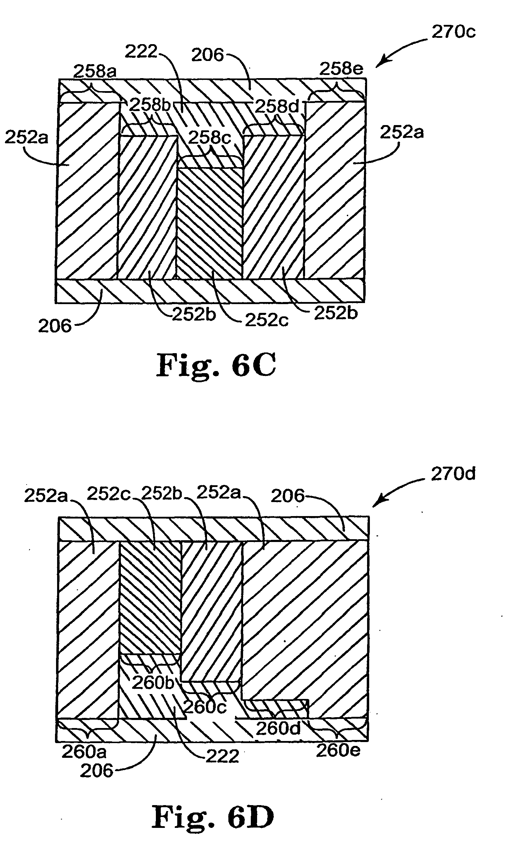

Figure 6C illustrates a top view of another embodiment of a phase change memory cell 270c. In one embodiment, each of the memory cells 106a-106d is similar to phase change memory cell 270c. Phase change memory cell 270c is similar to phase change memory cell 250c previously described and illustrated with reference to Figure 5D, except that phase change memory cell 270c includes dielectric material 222. Dielectric material 222 includes any suitable dielectric material, such as low-k material.

Dielectric material 222 contacts insulation material 206 and phase change materials 252a-252c. Dielectric material 222 contacts the side of the step-like pattern provided by phase change portions 258b-258d, and varies the thermal environment of phase change portions 258b-258d. In one embodiment, dielectric material 222 has a lower thermal conductivity than insulation material 206. By varying the thermal environment of phase change portions 258b-258d, the temperature induced within each phase change portion 258b-258d is further controlled during programming. Phase change memory cell 270c operates similarly to phase change memory cell 200c previously described and illustrated with reference to Figure 2D.

Figure 6D illustrates a top view of another embodiment of a phase change memory cell 270d. In one embodiment, each of the memory cells 106a-106d is similar to phase change memory cell 270d. Phase change memory cell 270d is similar to phase change memory cell 250d previously described and illustrated with reference to Figure 5E, except that phase change memory cell 270d includes dielectric material 222. Dielectric material 222 includes any suitable dielectric material, such as low-k material.

Dielectric material 222 contacts insulation material 206 and phase change materials 252a-252c. Dielectric material 222 contacts the side of the step-like pattern provided by phase change portions 260b-260d, and varies the thermal environment of phase change portions 260b-260d. In one embodiment, dielectric material 222 has a lower thermal conductivity than insulation material 206. By varying the thermal environment of phase change portions 260b-260d, the temperature induced within each phase change portion 260b-260d is further controlled during programming. Phase change memory cell 270d operates similarly to phase change memory cell 200d previously described and illustrated with reference to Figure 2E.

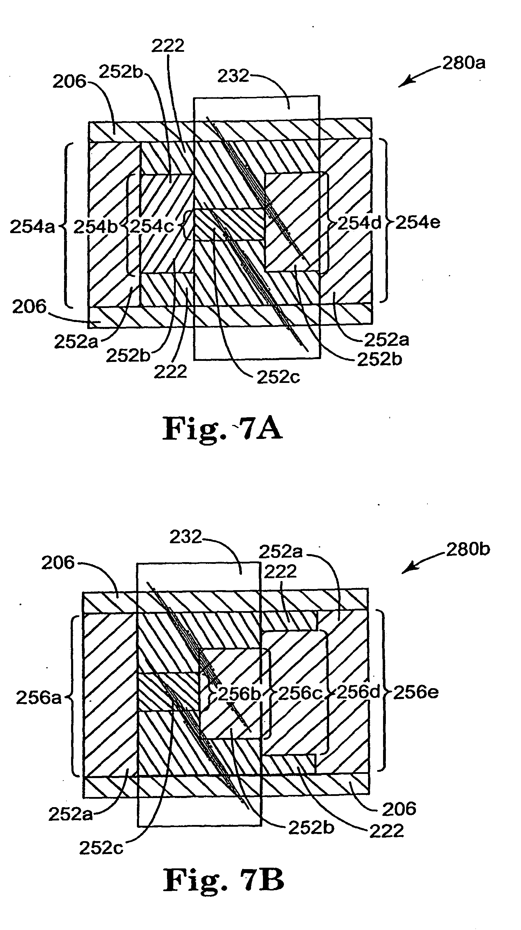

Figure 7A illustrates a top view of another embodiment of a phase change memory cell 280a. In one embodiment, each of the memory cells 106a-106d is similar to phase change memory cell 280a. Phase change memory cell 280a is similar to phase change memory cell 230a previously described and illustrated with reference to Figure 4A, except that in phase change memory cell 280a phase change material 208 is replaced with phase change materials 252a-252c and phase change portions 210a-210e are replaced with phase change portions 254a-254e.

Dielectric layer 232 contacts the top of third phase change portion 254c and fourth phase change portion 254d, and varies the thermal environment of third phase change portion 254c and third phase change portion 254d. In one embodiment, dielectric layer 232 has a lower thermal conductivity than insulation material 206. By varying the crystallization temperature and the thermal environment of phase change portions 254c-254d, the transition of each phase change portion 254c-254d is further controlled during programming. Phase change memory cell 280a operates similarly to phase change memory cell 230a previously described and illustrated with reference to Figure 4A.

Figure 7B illustrates a top view of another embodiment of a phase change memory cell 280b. In one embodiment, each of the memory cells 106a-106d is similar to phase change memory cell 280b. Phase change memory cell 280b is similar to phase change memory cell 230b previously described and illustrated with reference to Figure 4C, except that in phase change memory cell 280b phase change material 208 is replaced with phase change materials 252a-252c and phase change portions 212a-212e are replaced with phase change portions 256a-256e.

Dielectric layer 232 contacts second phase change portion 256b and third phase portion 256c, and varies the thermal environment of second phase change portion 256b and third phase change portion 256c. In one embodiment, dielectric layer 232 has a lower thermal conductivity than insulation material 206. By varying the crystallization temperature and the thermal environment of phase change portions 256b and 256c, the transition of each phase change portion 256b and 256c is further controlled during programming. Phase change memory cell 280b operates similarly to phase change memory cell 230b previously described and illustrated with reference to Figure 4C.

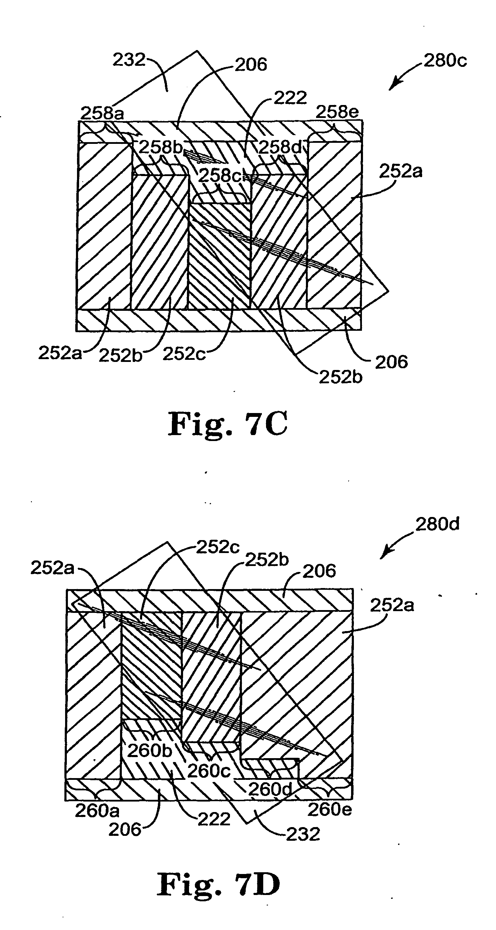

Figure 7C illustrates a top view of another embodiment of a phase change memory cell 280c. In one embodiment, each of the memory cells 106a-106d is similar to phase change memory cell 280c. Phase change memory cell 280c is similar to phase change memory cell 230c previously described and illustrated with reference to Figure 4D, except that in phase change memory cell 280c phase change material 208 is replaced with phase change materials 252a-252c and phase change portions 214a-214e are replaced with phase change portions 258a-258e.

Dielectric layer 232 contacts the top of fourth phase change portion 258d and portions of the tops of second and third phase change portions 258b and 258c, and varies the thermal environment of phase change portions 258b-258d. In one embodiment, dielectric layer 232 has a lower thermal conductivity than insulation material 206. By varying the crystallization temperature and the thermal environment of phase change portions 258b-258d, the transition of each phase change portion 258b-258d is further controlled during programming. Phase change memory cell 280c operates similarly to phase change memory cell 230c previously described and illustrated with reference to Figure 4D.

Figure 7D illustrates a top view of another embodiment of a phase change memory cell 280d. In one embodiment, each of the memory cells 106a-106d is similar to phase change memory cell 280d. Phase change memory cell 280d is similar to phase change memory cell 230d previously described and illustrated with reference to Figure 4E, except that in phase change memory cell 280d phase change material 208 is replaced with phase change materials 252a-252c and phase change portions 216a-216e are replaced with phase change portions 260a-260e.

Dielectric layer 232 contacts the top of third phase change portion 260c and portions of the tops of second phase change portion 260b and fourth phase change portion 260d, and varies the thermal environment of phase change portions 260b-260d. In one embodiment, dielectric layer 232 has a lower thermal conductivity than insulation material 206. By varying the crystallization temperature and the thermal environment of phase change portions 260b-260d, the transition of each phase change portion 260b-260d is further controlled during programming. Phase change memory cell 280d operates similarly to phase change memory cell 230d previously described and illustrated with reference to Figure 4E.

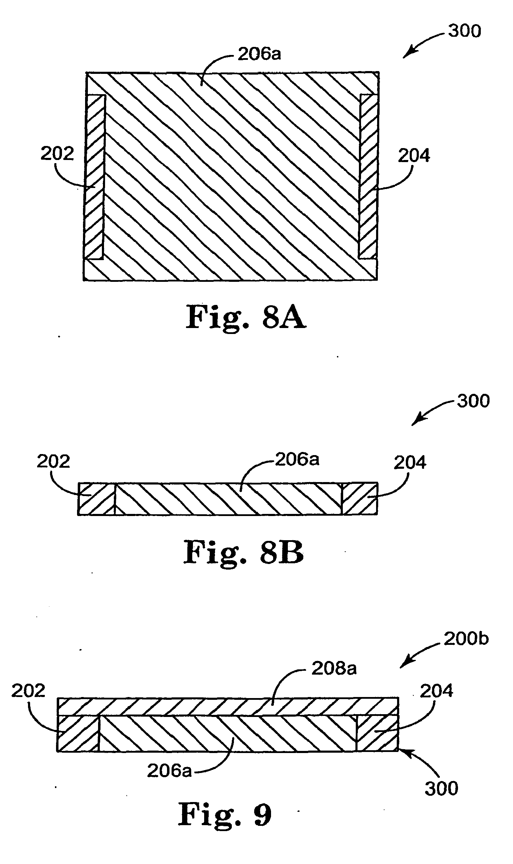

The following Figures 8A-18 illustrate embodiments of a method for fabricating phase change memory cells 200a-200d previously described and illustrated with reference to Figures 2A-2E, phase change memory cells 220a-220d previously described and illustrated with reference to Figures 3A-3D, and phase change memory cells 230a-230d previously described and illustrated with reference to Figures 4A-4E.

Figure 8A illustrates a top view of one embodiment of a preprocessed wafer 300. Figure 8B illustrates a side cross-sectional view of one embodiment of preprocessed wafer 300. Preprocessed wafer 300 includes a first electrode 202, a second electrode 204, insulation material 206a, and lower wafer layers (not shown). First electrode 202 and second electrode 204 include any suitable electrode material, such as TiN, TaN, W, TiSiN, TiAlN, TaSiN, or TaAlN. First electrode 202 and second electrode 204 are laterally surrounded by insulation material 206a, such as SiO₂, FSG, BPSG, BSG, low-k material, or other suitable dielectric material.

Figure 9 illustrates a side cross-sectional view of one embodiment of preprocessed wafer 300 and a phase change material layer 208a. Phase change material, such as a chalcogenide compound material or other suitable phase change material, is deposited over preprocessed wafer 300 to provide phase change material layer 208a. Phase change material layer 208a is deposited using chemical vapor deposition (CVD), atomic layer deposition (ALD), metal organic chemical vapor deposition (MOCVD), plasma vapor deposition (PVD), jet vapor deposition (JVP), or other suitable deposition technique.

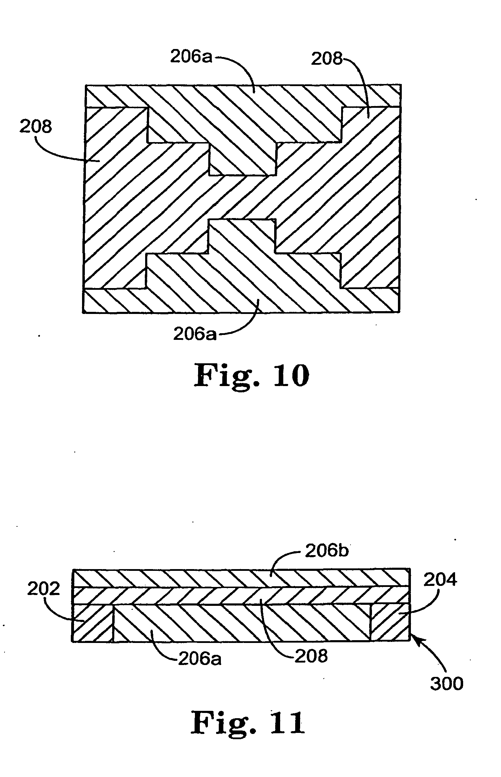

Figure 10 illustrates a top view of one embodiment of preprocessed wafer 300 and phase change material 208 after etching phase change material layer 208a. Phase change material layer 208a is etched to provide a step-like pattern of phase change material 208.

In one embodiment, phase change material 208 includes phase change portions 210a-210e of memory cell 200a as described and illustrated with reference to Figure 2A. In another embodiment, phase change portions 210a-210e are replaced with phase change portions 212a-212e of memory cell 200b as described and illustrated with reference to Figure 2C. In another embodiment, phase change portions 210a-210e are replaced with phase change portions 214a-214e of memory cell 200c as described and illustrated with reference to Figure 2D. In another embodiment, phase change portions 210a-210e are replaced with phase change portions 216a-216e of memory cell 200d as described and illustrated with reference to Figure 2E.

Figure 11 illustrates a side cross-sectional view of one embodiment of preprocessed wafer 300, phase change material 208, and additional insulation material layer 206b. Insulation material, such as SiO₂, FSG, BPSG, BSG, low-k material, or other suitable dielectric material, is deposited over exposed portions of preprocessed wafer 300 and phase change material 208 to provide insulation material layer 206b. Insulation material layer 206b is deposited using CVD, ALD, MOCVD, PVD, JVP, or other suitable deposition technique.

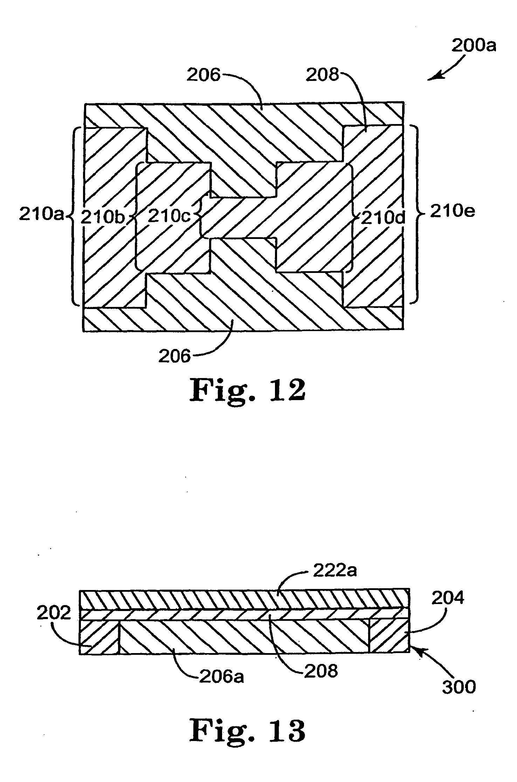

Figure 12 illustrates a top view of one embodiment of preprocessed water, 300, phase change material 208, and insulation material 206 after planarizing additional insulation material layer 206b. Additional insulation material layer 206b is planarized using chemical mechanical planarization (CMP) or another suitable planarization technique to expose phase change material 208 and to provide phase change memory cell 200a as described and illustrated with reference to Figure 2A. In other embodiments, additional insulation material layer 206b is planarized to provide phase change memory cell 200b as described and illustrated in reference to Figure 2C, phase change memory cell 200c as described and illustrated with reference to Figure 2D, phase change memory cell 200d as described and illustrated with reference to Figure 2E, or other suitable phase change memory cell 200.

Figure 13 illustrates a side cross-sectional view of one embodiment of preprocessed wafer 300, phase change material 208, and a dielectric material layer 222a. Dielectric material, such as low-k material or other suitable dielectric material, is deposited over exposed portions of preprocessed wafer 300 and phase change material 208 (as illustrated in Figure 10) to provide dielectric material layer 222a. Dielectric material layer 222a is deposited using CVD, ALD, MOCVD, PVD, JVP, or other suitable deposition technique.

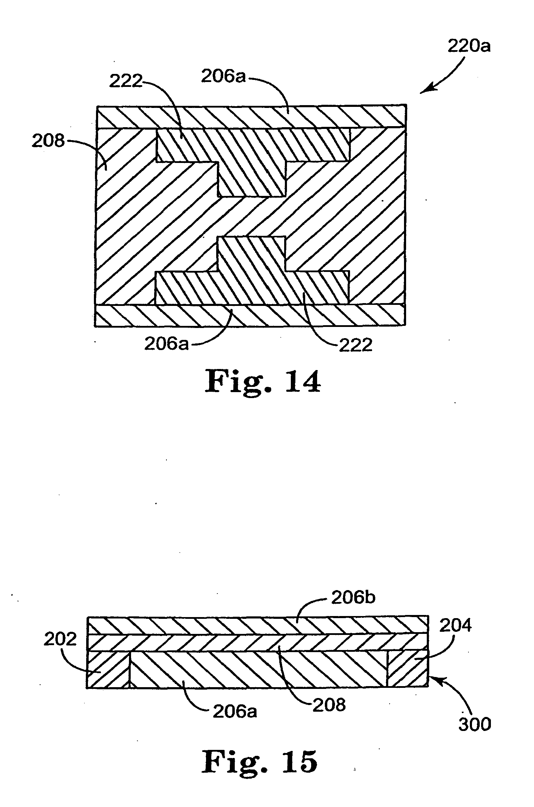

Figure 14 illustrates a top view of one embodiment of preprocessed wafer 300, phase change material 208, and dielectric material 222 after planarizing and etching dielectric material layer 222a to expose preprocessed wafer 300 and phase change material 208. Dielectric material layer 222a is planarized and etched to provide dielectric material 222.

Figure 15 illustrates a side cross-sectional view of one embodiment of preprocessed wafer 300, phase change material 208, dielectric material 222 (not shown), and an additional insulation material layer 206b. Insulation material, such as SiO₂, FSG, BPSG, BSG, low-k material, or other suitable dielectric material, is deposited over exposed portions of preprocessed wafer 300, phase change material 208; and dielectric material 222 to provide insulation material layer 206b. Insulation material layer 206b is deposited using CVD, ALD, MOCVD, PVD, JVP, or other suitable deposition technique.

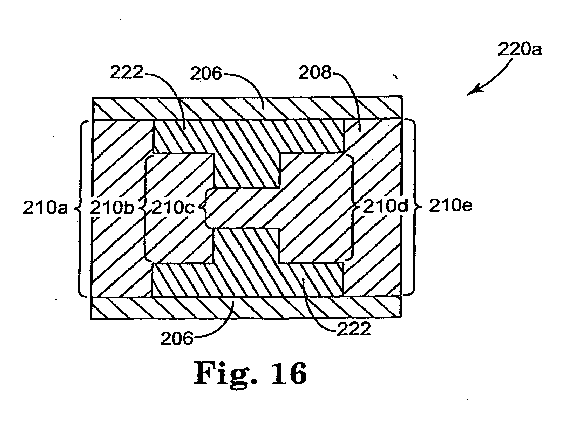

Figure 16 illustrates a top view of one embodiment of preprocessed wafer 300, phase change material 208, dielectric material 222, and insulation material 206 after planarizing additional insulation material layer 206b. Additional insulation material layer 206b is planarized using CMP or another suitable planarization technique to expose phase change material 208 and dielectric material 222 and to provide phase change memory cell 220a as described and illustrated with reference to Figure 3A. In other embodiments, additional insulation material layer 206b is planarized to provide phase change memory cell 220b as described and illustrated with reference to Figure 3B, phase change memory cell 220c as described and illustrated with reference to Figure 3C, phase change memory cell 220d as described and illustrated with reference to Figure 3D, or other suitable phase change memory cell 220.

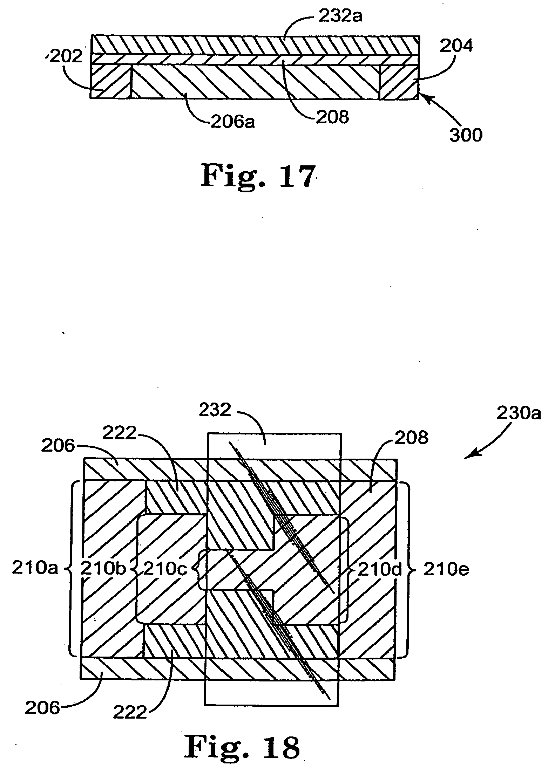

Figure 17 illustrates a side cross-sectional view of one embodiment of preprocessed wafer 300, phase change material 208, and insulation material 206 (as illustrated in Figure 14), and a dielectric material layer 232a. Dielectric material, such as low-k material or other suitable dielectric material, is deposited over phase change material 208, insulation material 206, and dielectric material 222 to provide dielectric material layer 232a.

Figure 18 illustrates a top view of one embodiment of preprocessed wafer 300 (not shown), phase change material 208, insulation material 206, and dielectric layer 232 after etching dielectric material layer 232a. Dielectric material layer 232a is patterned and etched to provide dielectric layer 232. In one embodiment, dielectric layer 232 contacts third phase change portion 210c and fourth phase change portion 210d to provide phase change memory cell 230a as described and illustrated with reference to Figure 4A. In another embodiment, dielectric layer 232 contacts second phase change portion 212b and third phase change portion 212c to provide phase change memory cell 230b as described and illustrated with reference to Figure 4C. In another embodiment, dielectric layer 232 contacts fourth phase change portion 214d and portions of second and third phase change portions 214b and 214c to provide phase change memory cell 230c as described and illustrated with reference to Figure 4D. In another embodiment, dielectric layer 232 contacts portions of phase change portions 216a-216e to provide phase change memory cell 230d as described and illustrated with reference to Figure 4E. In other embodiments, dielectric layer 232 contacts any suitable phase change portions to provide a phase change memory cell 230.

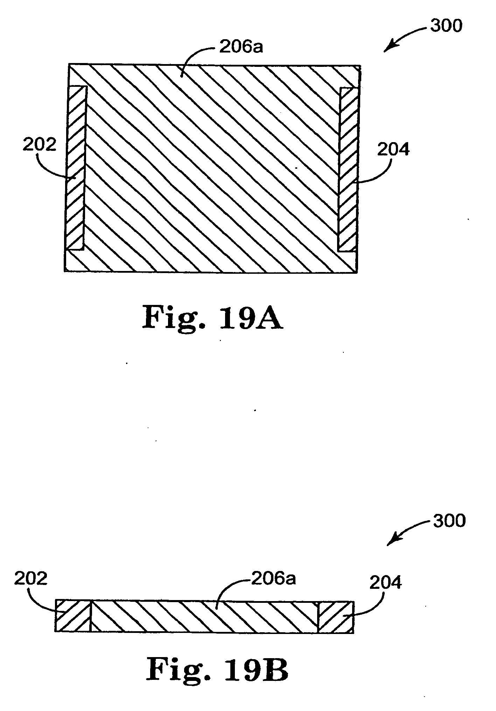

The following Figures 19A-24 illustrate embodiments of a method for fabricating phase change memory cells 250a-250d previously described and illustrated with reference to Figures 5A-5E, phase change memory cells 270a-270d previously described and illustrated with reference to Figures 6A-6D, and phase change memory cells 280a-280d previously described and illustrated with reference to Figures 7A-7D.

Figure 19A illustrates a top view of one embodiment of preprocessed wafer 300. Figure 19B illustrates a side cross-sectional view of one embodiment of preprocessed wafer 300. Preprocessed wafer 300 includes a first electrode 202, a second electrode 204, insulation material 208, and lower wafer layers (not shown). First electrode 202 and second electrode 204 include any suitable electrode material, such as TiN, TaN, W, TiSiN, TiAlN, TaSiN, or TaAlN. First electrode 202 and second electrode 204 are laterally surrounded by insulation material 208, such as SiO₂, FSG, BPSG, BSG, low-k material, or other suitable dielectric material.

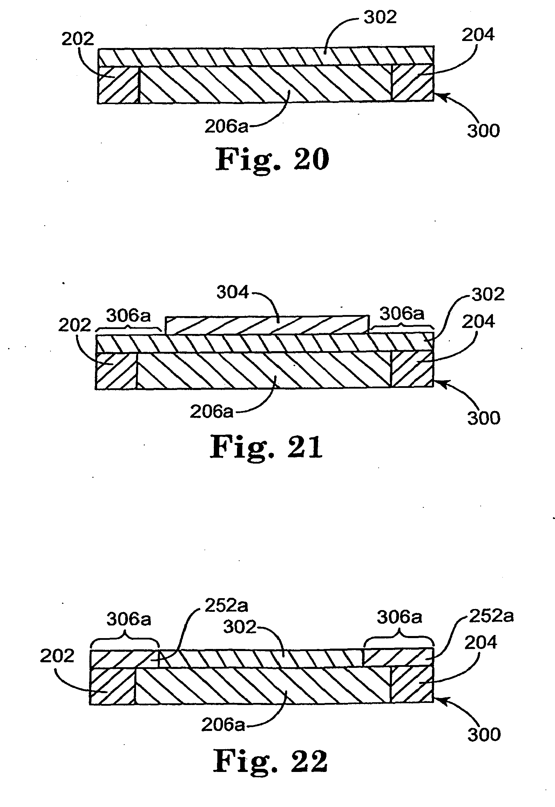

Figure 20 illustrates a side cross-sectional view of one embodiment of preprocessed wafer 300 and a phase change material layer 302. Phase change material, such as a chalcogenide compound material or other suitable phase change material, is deposited over preprocessed wafer 3 00 to provide phase change material layer 302. Phase change material layer 302 is deposited using CVD, ALD, MOCVD, PVD, JVP, or other suitable deposition technique.

Figure 21 illustrates a side cross-sectional view of one embodiment of preprocessed wafer 300, phase change material layer 302, and a protective material layer 304a. A protective material, such as a photoresist, hard mask, spacer material, or other suitable protective material, is deposited over phase change material layer 302. The protective material is etched to expose portions 306a of phase change material layer 302 and to provide protective material layer 304. In one embodiment, ion implantation is performed to modify exposed portions 306a of phase change material layer 302 to a different phase change material. In another embodiment, the exposed portions 306a of phase change material layer 302 are exposed to a reactive gas to modify exposed portions 306a of phase change material layer 302 to a different phase change material. In another embodiment, a material is deposited over exposed portions 306a of phase change material layer 302 and annealed to modify exposed portions 306a of phase change material layer 302 to a different phase change material. In other embodiments, other suitable techniques can be used to modify exposed portions 306a of phase change material layer 302 to a different phase change material.

Figure 22 illustrates a side cross-sectional view of one embodiment of preprocessed wafer 300 and modified phase change material layer 302 after removing protective material layer 304. Exposed portions 306a of phase change material layer 302 have been modified to phase change material 252a. The process described and illustrated with reference to Figures 21 and 22 is repeated a suitable number of times to further modify phase change material layer 302 to different phase change materials.

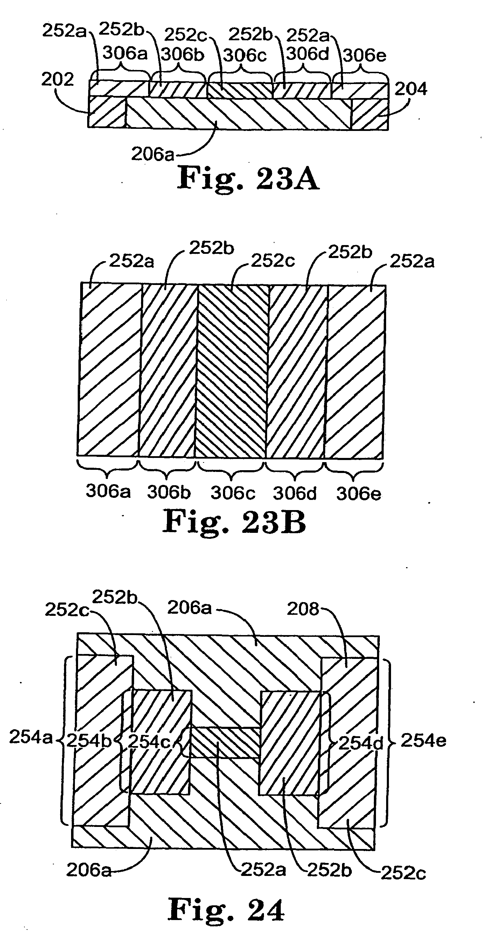

Figure 23A illustrates a side cross-sectional view of one embodiment of preprocessed wafer 300 and multiple phase change portions 306a-306e. Figure 23B illustrates a top view of one embodiment of preprocessed wafer 300 and multiple phase change portions 306a-306e. In one embodiment, phase change portions 306a and 306e have been modified to include phase change material 252a, phase change portions 306b and 306d have been modified to include phase change material 252b, and phase change portion 306c has been modified to include phase change material 252c. In another embodiment, at least one of the phase change portions 306a-306e is not modified, but rather includes the original phase change material deposited to provide phase change material layer 302.

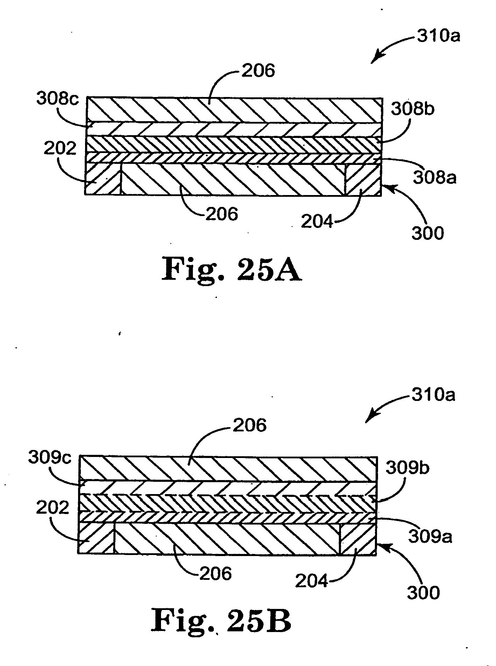

Figure 24 illustrates a top view of one embodiment of phase change portions 254a-254e after etching phase change portions 306a-306e. Phase change portions 306a-306e are etched to provide phase change portions 254a-254e of memory cell 250a as previously described and illustrated with reference to Figure 5A. In other embodiments, phase change portions 306a-306e include other phase change materials and are etched to provide phase change portions 256a-256e of memory cell 250b as previously described and illustrated with reference to Figure 5C, phase change portions 258a-258e of memory cell 250c as previously described and illustrated with reference to Figure 5D, phase change portions 260a-260e of memory cell 250d as previously described and illustrated with reference to Figure 5E, or other suitable phase change portions of a memory cell 250.

Further processing as described and illustrated with reference to Figures 11-18 is then performed to fabricate memory cells 270a-270d as previously described and illustrated with reference to Figures 6A-6D and memory cells 280a-280d as previously described and illustrated with reference to Figures 7A-7D.

Figure 25A illustrates a side cross-sectional view of one embodiment of a phase change memory cell 310a with multiple phase change material layers in a stack. The phase change memory cell 310a includes a first electrode 202, a second electrode 204, insulation material 206, a first phase change material layer 308a, a second phase change material layer 308b, and a third phase change material layer 308c. First phase change material layer 308a contacts first electrode 202, second electrode 204, insulation material 206, and second phase change material layer 308b. Second phase change material layer 308b contacts third phase change material layer 308c. Third phase change material layer 308d contacts insulation material 206.

In one embodiment, first phase change material layer 308a is deposited over preprocessed wafer 300. Second phase change material layer 308b is deposited over first phase change material layer 308a. Third phase change material layer 308c is deposited over second phase change material layer 308b. Insulation material 206 is deposited over third phase change material layer 308c. In one embodiment, at least two of the phase change material layers 308a-308c have different crystallization temperatures. By varying the crystallization temperature between the phase change material layers 308a-308c, the transition of each phase change material layer 308a-308c can be controlled during programming to program memory cell 310a to a selected state. In one embodiment, memory cells 200a-200d, 220a-220d, and 230a-230d include phase change material layers 308a-308c in place of phase change material 208. In one embodiment, phase change material layers 308a-308c may be separated by thin diffusion barriers preventing an intermixing of the different materials. In one embodiment, these diffusion barriers include a material having a higher resistivity than the phase change materials.

Figure 25B illustrates a side cross-sectional view of another embodiment of a phase change memory cell 310b with multiple phase change material layers in a stack. Phase change memory cell 310b is similar to phase change memory cell 310a previously described and illustrated with reference to Figure 25A, except that phase change material layers 309a-309c gradually transition from one phase change material to the next phase change material between layers. Phase change memory cell 310b operates similarly to phase change memory cell 310a previously described and illustrated with reference to Figure 25A.

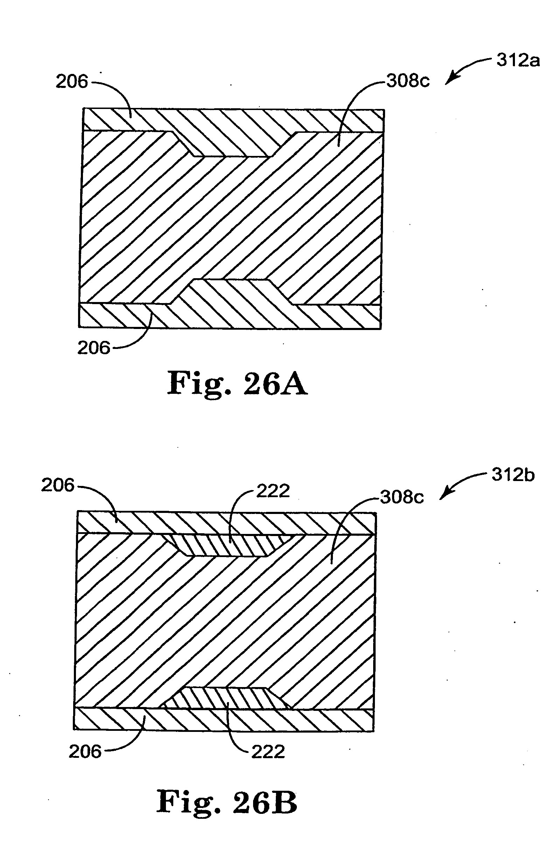

Figure 26A illustrates a top view of another embodiment of a phase change memory cell 312a with multiple phase change material layers in a stack. In one embodiment, each of the memory cells 106a-106d is similar to phase change memory cell 312a. Phase change memory cell 312a includes a stack of phase change material layers 308a-308c or 309a-309c in an hourglass or "I" shaped configuration. A selection device such as an active device like a transistor or diode, may be electrically coupled to first electrode 202 or second electrode 204 to control the application of current or voltage pulses to the other of first electrode 202 or second electrode 204, and thus to phase change material layers 308a-308c, to set and reset phase change material layers 308a-308c. In one embodiment, the crystallization temperature of phase change material layer 308a is less than the crystallization temperature of phase change material layers 308b and 308c. The crystallization temperature of phase change material layer 308b is less than the crystallization temperature of phase change material layer 308c. Thus, a current or voltage pulse having a lower amplitude and/or duration is used to program phase change material layer 308a than to program phase change material layers 308b and 308c. Further, a current or voltage pulse having a lower amplitude and/or duration is used to program phase change material layer 308b than to program phase change material layer 308c.

During operation of phase change memory cell 312a, current or voltage pulses are applied between first electrode 202 and second electrode 204 to program phase change memory cell 312a. A first current or voltage pulse having a first amplitude and/or duration programs phase change material layer 308a without significantly affecting phase change material layers 308b and 308c. A second current or voltage pulse having a second amplitude and/or duration programs phase change material layers 308a and 308b without significantly affecting phase change material layer 308c. The second amplitude and/or duration is greater than the first amplitude and/or duration. A third current or voltage pulse having a third amplitude and/or duration programs phase change material layers 308a-308c. The third amplitude and/or duration is greater than the second amplitude and/or duration.

By selectively programming phase change material layers 308a-308c, phase change memory cell 312a can be programmed to provide four states. In one embodiment, in a first state, phase change material layers 308a-308c are amorphous. In a second state, phase change material layer 308a is crystalline, and phase change material layers 308b and 308c are amorphous. In a third state, phase change material layers 308a and 308b are crystalline, and phase change material layer 308c is amorphous. In a fourth state, phase change material layers 308a-308c are crystalline.

In another embodiment, in a first state, phase change material layers 308a-308c are crystalline. In a second state, phase change material layer 308a is amorphous, and phase change material layers 308b and 308c are crystalline. In a third state, phase change material layers 308a and 308b are amorphous, and phase change material layer 308c is crystalline. In a fourth state, phase change material layers 308a-308c are amorphous. In other embodiments, any suitable number of phase change material layers 308 are used for obtaining a desired number of states in phase change memory cell 312a.

Figure 26B illustrates a top view of another embodiment of a phase change memory cell 312b including phase change material layers 308a-308c. In one embodiment, each of the memory cells 106a-106d is similar to phase change memory cell 312b. Phase change memory cell 312b is similar to phase change memory cell 312a previously described and illustrated with reference to Figure 26A, except that phase change memory cell 312b includes dielectric material 222. Dielectric material 222 includes any suitable dielectric material, such as low-k material.

Dielectric material 222 contacts insulation material 206 and phase change material layers 308a-308c. Dielectric material 222 surrounds the center of the hourglass or "I" shaped pattern provided by phase change material layers 308a-308c, and varies the thermal environment of phase change material layers 308a-308c. In one embodiment, dielectric material 222 has a lower thermal conductivity than insulation material 206. By varying the thermal environment of phase change material layers 308a-308c, the temperature induced within each phase change material layer 308a-308c is further controlled during programming. Phase change memory cell 312b operates similarly to phase change memory cell 312a previously described and illustrated with reference to Figure 26A.

Embodiments of the methods described and illustrated with reference to Figures 8A-26B can be subdivided and/or combined to fabricate memory cells including phase change material forming step-like patterns as illustrated in Figures 2A-2E, memory cells including step-like patterns and varying thermal environments as illustrated in Figures 3A-3D, memory cells including step-like patterns and a dielectric layer as illustrated in Figures 4A-4E, memory cells including step-like patterns using different phase change materials as illustrated in Figures 5A-5E, memory cells including step-like patterns using different phase change materials and varying thermal environments as illustrated in Figures 6A-6D, memory cells including step-like patterns using different phase change materials and a dielectric layer as illustrated in Figures 7A-7D, memory cells including a stack of phase change material layers as illustrated in Figures 25A-26B, or combinations thereof.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A memory cell comprising:
a first electrode;
a second electrode; and
phase change material contacting the first electrode and the second electrode, the phase change material having a step-like programming characteristic,
wherein the first electrode, the second electrode, and the phase change material form a planar or bridge phase change memory cell.

2. The memory cell of claim 1, wherein the phase change material forms a step-like pattern between the first electrode and the second electrode.

3. The memory cell of claim 2, wherein the phase change material comprises a plurality of rectangular portions.

4. The memory cell of claim 1, further comprising:
a first insulation material contacting a first vertical side portion of the phase change material and a second insulation material contacting a second vertical side portion of the phase change material, the second insulation material having a lower thermal conductivity than the first insulation material.

5. The memory cell of claim 4, wherein the second insulation material comprises low-k material.

6. The memory cell of claim 2, further comprising:
a dielectric layer contacting a horizontal side portion of the step-like pattern.

7. A memory cell comprising:
a first electrode;
a second electrode; and
a phase change material layer contacting the first electrode and the second electrode, the phase change material layer comprising at least two different phase change materials arranged horizontally between the first electrode and the second electrode to provide a step-like programming characteristic.

8. The memory cell of claim 7, wherein the phase change material layer forms a step-like pattern.

9. The memory cell of claim 8, wherein the phase change material layer comprises a plurality of rectangular portions.

10. The memory cell of claim 7, further comprising:
a first insulation material contacting a first vertical side portion of the phase change material layer and a second insulation material contacting a second vertical side portion of the phase change material layer, the second insulation material having a lower thermal conductivity than the first insulation material.

11. The memory cell of claim 10, wherein the second insulation material comprises low-k material.

12. The memory cell of claim 8, further comprising:
a dielectric layer contacting a horizontal side portion of the step-like pattern.

13. A memory cell comprising:
a first electrode;
a second electrode; and
a stack of phase change material layers contacting the first electrode and the second electrode, at least two of the phase change material layers including different phase change materials to provide a step-like programming characteristic.

14. The memory cell of claim 13, wherein the stack of phase change material layers form a step-like pattern between the first electrode and the second electrode.

15. The memory cell of claim 13, wherein the stack of phase change material layers gradually transitions between different phase change materials between each phase change material layer.

16. The memory cell of claim 13, wherein the phase change material layers are separated by diffusion barriers.

17. The memory cell of claim 16, wherein the diffusion barriers comprise a material having a higher resistivity than the phase change material layers.

18. The memory cell of claim 13, further comprising:
a first insulation material contacting a first vertical side portion of the stack of phase change material layers and a second insulation material contacting a second vertical side portion of the stack of phase change material layers, the second insulation material having a lower thermal conductivity than the first insulation material.

19. The memory cell of claim 18, wherein the second insulation material comprises low-k material.

20. The memory cell of claim 14, further comprising:
a dielectric layer contacting a horizontal side portion of the step-like pattern.

21. A method for fabricating a memory cell, the method comprising:
providing a wafer comprising a first electrode, a second electrode, and a first insulation material layer between the first electrode and the second electrode;
depositing a phase change material layer over the wafer; and
etching the phase change material layer to expose a first portion of the wafer and to form a step-like pattern in the phase change material layer between the first electrode and the second electrode.

22. The method of claim 21, further comprising:
depositing a second insulation material layer over the first portion of the wafer and the etched phase change material layer; and
planarizing the second insulation material layer to expose the etched phase change material layer.

23. The method of claim 22, further comprising:
etching the second insulation material layer to expose a second portion of the wafer spaced apart from at least a portion of the etched phase change material layer;
depositing a third insulation material layer over the second portion of the wafer and the etched phase change material layer; and
planarizing the third insulation material layer to expose the etched phase change material layer and the etched second insulation material layer.

24. The method of claim 22, further comprising:
depositing a dielectric layer over the etched phase change material layer and the planarized second insulation material layer; and
etching the dielectric layer to expose a portion of the etched phase change material layer.

25. The method of claim 23, further comprising:
depositing a dielectric layer over the etched phase change material layer, the planarized second insulation material layer, and the planarized third insulation material layer; and
etching the dielectric layer to expose a portion of the etched phase change material layer.

26. A method for fabricating a memory cell, the method comprising:
providing a wafer comprising a first electrode, a second electrode, and a first insulation material layer between the first electrode and the second electrode;
depositing a stack of phase change material layers over the wafer, at least two of the phase change material layers comprising different phase change materials; and
etching the stack of phase change material layers to expose a first portion of the wafer and to form a planar bridge of etched phase change material layers between the first electrode and the second electrode.

27. The method of claim 26, wherein etching the stack of phase change material layers comprises etching the stack of phase change material layers to form a step-like pattern in the stack of phase change material layers between the first electrode and the second electrode.

28. The method of claim 26, further comprising:
depositing a second insulation material layer over the first portion of the wafer and the etched stack of phase change material layers; and
planarizing the second insulation material layer to expose the etched stack of phase change material layers.

29. The method of claim 28, further comprising:
etching the second insulation material layer to expose a second portion of the wafer spaced apart from at least a portion of the etched stack of phase change material layers;
depositing a third insulation material layer over the second portion of the wafer and the etched stack of phase change material layers; and
planarizing the third insulation material layer to expose the etched stack of phase change material layers and the second insulation material layer.

30. The method of claim 29, further comprising:
depositing a dielectric layer over the etched stack of phase change material layers, the planarized second insulation material layer, and the planarized third insulation material layer; and
etching the dielectric layer to expose a portion of the etched stack of phase change material layers.

31. The method of claim 28, further comprising:
depositing a dielectric layer over the etched stack of phase change material layers and the planarized second insulation material layer; and
etching the dielectric layer to expose a portion of the etched stack of phase change material layers.

32. A method for fabricating a memory cell, the method comprising:
providing a wafer comprising a first electrode, a second electrode, and a first insulation material layer between the first electrode and the second electrode;
depositing a first phase change material over the wafer;
modifying at least a first portion of the first phase change material to provide a second phase change material; and
etching the first and second phase change material to expose a first portion of the wafer and to form a step-like pattern in the first and second phase change material between the first electrode and the second electrode.

33. The method of claim 32, further comprising:
depositing a second insulation material layer over the first portion of the wafer and the etched first and second phase change material; and
planarizing the second insulation material layer to expose the etched first and second phase change material.

34. The method of claim 33, further comprising:
etching the second insulation material layer to expose a second portion of the wafer spaced apart from at least a portion of the etched first and second phase change material;
depositing a third insulation material layer over the second portion of the wafer and the etched first and second phase change material; and
planarizing the third insulation material layer to expose the etched first and second phase change material and the etched second insulation material layer.

35. The method of claim 33, further comprising:
depositing a dielectric layer over the etched first and second phase change material and the planarized second insulation material layer; and
etching the dielectric layer to expose a portion of the etched first and second phase change material.

36. The method of claim 34, further comprising:
depositing a dielectric layer over the etched first and second phase change material, the planarized second insulation material layer, and the planarized third insulation material layer; and
etching the dielectric layer to expose a portion of the etched first and second phase change material.

37. The method of claim 32, wherein modifying at least a first portion of the first phase change material to provide the second phase change material comprises:
depositing a protective material layer over the first phase change material;
etching the protective material layer to expose the first portion of the first phase change material; and
implanting the first portion of the first phase change material with ions to provide the second phase change material.

38. The method of claim 32, wherein modifying at least a first portion of the first phase change material to provide the second phase change material comprises:
depositing a protective material layer over the first phase change material;
etching the protective material layer to expose the first portion of the first phase change material ; and
exposing the first portion of the first phase change material to a reactive gas to provide the second phase change material.

39. The method of claim 32, wherein modifying at least a first portion of the first phase change material to provide the second phase change material comprises:
depositing a protective material layer over the first phase change material;
etching the protective material layer to expose the first portion of the first phase change material;
depositing a first material over the first portion of the first phase change material; and
annealing the first portion of the first phase change material and the first material to provide the second phase change material.
